# EUROPEAN PATENT APPLICATION

(11) **EP 4 445 761 A1**
(43) Date of publication of application: **16.10.2024**
(21) Application number: 21967256.5
(22) Date of filing: 10.12.2021
(51) Int. Cl.: A24F 40/40

(54) **POWER SUPPLY UNIT FOR AEROSOL GENERATING DEVICE**

(71) Applicant: Japan Tobacco Inc., Tokyo 105-6927 (JP)
(72) Inventor: MARUBASHI Keiji, Tokyo 130-8603 (JP); KITAHARA Minoru, Tokyo 130-8603 (JP)
(74) Representative: Hoffmann Eitle
(86) International application number: PCT/JP2021/045588
(87) International publication number: WO 2023/105764

(57) **Abstract**

The present invention provides a power supply unit for an aerosol generating device that makes it possible to achieve a size reduction even when many connectors are included. A power supply unit 100 comprises: a power supply ba; a main substrate 20 that includes a front surface 201 and a back surface 202); a case 3a that accommodates the power supply ba and the main substrate 20; a plurality of electronic components that are accommodated in the case 3a; and a plurality of first connectors (a main connector 20A, a heater connector 20B, an OLED connector 20C, and a battery connector 20D) that are respectively connected to the plurality of electronic components via a main FPC 23, a heater FPC 24, an OLED FPC 25, and a lead wire 16, wherein among the front surface 201 and the back surface 202, the plurality of first connectors are mounted only on the front surface 201.

## Description

### TECHNICAL FIELD

The present invention relates to a power supply unit for an aerosol generating device.

### BACKGROUND ART

Patent Literature 1 describes an aerosol generating device including a heater, a battery configured to supply power to heat the heater, a control portion, and a main PCB and an auxiliary PCB formed out of a rigid material, in which the main PCB is located parallel to a longitudinal direction of the aerosol generating device, and the auxiliary PCB is located perpendicular to the longitudinal direction of the aerosol generating device, and the main PCB and the auxiliary PCB are electrically connected to each other via a connecting PCB formed out of a flexible material.

### CITATION LIST

### PATENT LITERATURE

Patent Literature 1: JP2020-531015A

### SUMMARY OF INVENTION

### TECHNICAL PROBLEM

If the number of connectors connected to many electronic components mounted on a power supply unit for an aerosol generating device increases, miniaturization of the power supply unit is hindered.

An object of the present invention is to provide a power supply unit for an aerosol generating device that can be miniaturized even if many connectors are included.

### SOLUTION TO PROBLEM

A power supply unit for an aerosol generating device according to an aspect of the present invention includes: a power supply configured to supply power to an atomizer configured to atomize an aerosol source; a circuit board including a first main surface and a second main surface located back of the first main surface; a housing accommodating the power supply and the circuit board; a plurality of electronic components accommodated in the housing; and a plurality of first connectors respectively connected to the plurality of electronic components via a plurality of first wires provided outside the circuit board, in which the plurality of first connectors are mounted only on the first main surface of the first main surface and the second main surface.

### ADVANTAGEOUS EFFECTS OF INVENTION

According to the present invention, miniaturization can be achieved even when many connectors are included.

### BRIEF DESCRIPTION OF DRAWINGS

Fig. 1 is a perspective view of an aerosol generating device 200.
Fig. 2 is another perspective view of the aerosol generating device 200.
Fig. 3 is an exploded perspective view of the aerosol generating device 200.
Fig. 4 is a left side view of an internal unit 2A.
Fig. 5 is a right side view of the internal unit 2A.
Fig. 6 is a perspective view showing a configuration of a heating portion 60 and a circuit portion 70 of the internal unit 2A.
Fig. 7 is a diagram showing a front surface 201 of a main board 20.
Fig. 8 is a diagram showing a back surface 202 of the main board 20.
Fig. 9 is a plan view seen in a direction perpendicular to an element mounting surface of a puff sensor board 21 (in other words, a thickness direction of the puff sensor board 21).
Fig. 10 is an exploded perspective view of the puff sensor board 21, a sensor holding portion 55, and an inhalation sensor 15 shown in Fig. 9.
Fig. 11 is a perspective view of a chassis 50 with the sensor holding portion 55 removed.
Fig. 12 is a diagram showing a schematic configuration of a circuit provided on the main board 20.
Fig. 13 is a circuit diagram in which electronic components related to an operation of a heating mode are extracted from the circuit shown in Fig. 12.
Fig. 14 is a circuit diagram in which electronic components related to heating control on a seat heater HTR and a liquid heater, drive control on a vibration motor 13, and drive control on an LED 21D are extracted from the circuit shown in Fig. 12.
Fig. 15 is a circuit diagram corresponding to Fig. 13 when an FF 9 is omitted.
Fig. 16 is a circuit diagram corresponding to Fig. 13 when the FF 9 and an AND gate 10 are omitted.
Fig. 17 is an exploded perspective view of the heating portion 60 and a flow path forming body 19 shown in Fig. 6.
Fig. 18 is a developed view of a heater FPC 24 shown in Fig. 17.
Fig. 19 is a circuit diagram in which electronic components related to restarting of an MCU 6 are extracted from the circuit shown in Fig. 12.
Fig. 20 is a diagram showing a modification of a restart circuit RBT shown in Fig. 19.
Fig. 21 is a circuit diagram in which test points (white circles in the drawing) are added to Fig. 12.
Fig. 22 is a partially enlarged view of Fig. 21, and is an enlarged view of an upper left area when Fig. 21 is divided vertically and horizontally into four.
Fig. 23 is a partially enlarged view of Fig. 21, and is an enlarged view of a lower left area when Fig. 21 is divided vertically and horizontally into four.
Fig. 24 is a partially enlarged view of Fig. 21, and is an enlarged view of an upper right area when Fig. 21 is divided vertically and horizontally into four.
Fig. 25 is a partially enlarged view of Fig. 21, and is an enlarged view of a lower right area when Fig. 21 is divided vertically and horizontally into four.

### DESCRIPTION OF EMBODIMENTS

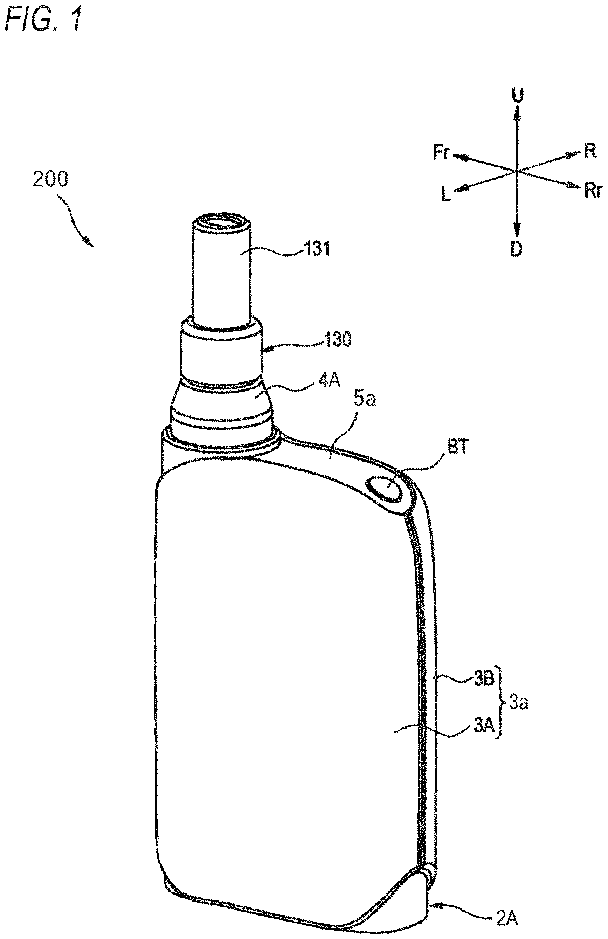

A power supply unit for an aerosol generating device which is an embodiment of the present invention will be described below. First, the aerosol generating device provided with the power supply unit according to the present embodiment will be described with reference to Figs. 1 to 8.

### (Aerosol Generating Device)

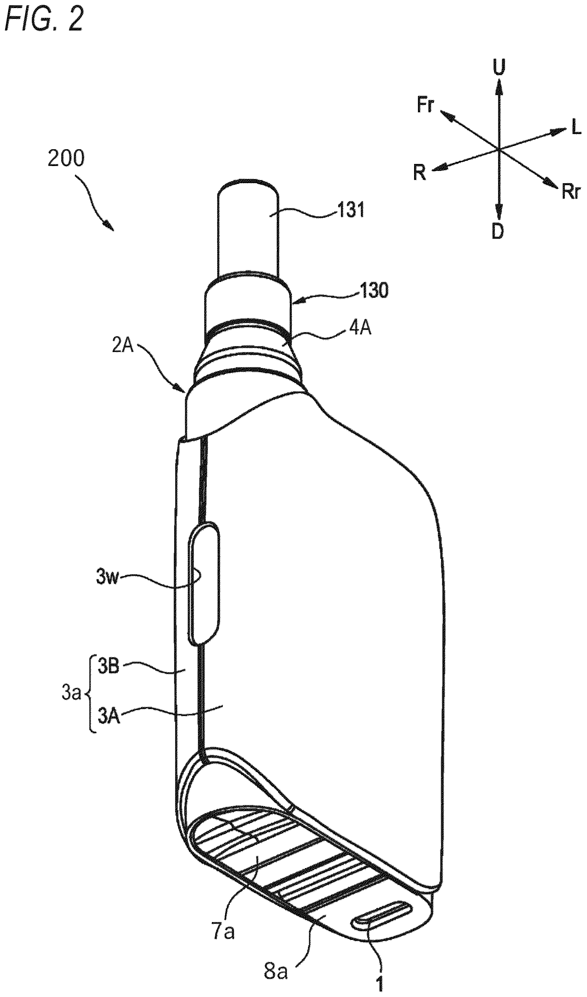

An aerosol generating device 200 is a tool for generating an aerosol added with a flavor without combustion and inhaling the generated aerosol. The aerosol generating device 200 preferably has a size that fits in a hand, and has, for example, a substantially rectangular parallelepiped shape with rounded corners as shown in Figs. 1 and 2. The shape of the aerosol generating device 200 is not limited to the above, and may be a bar shape, an egg shape, or the like. In the following description, in the aerosol generating device 200, three orthogonal directions are referred to as an up-down direction, a front-rear direction, and a left-right direction in a descending order of a length. In the following description, for the sake of convenience, as illustrated in Figs. 1 to 8, forward, rearward, leftward, rightward, upward, and downward are defined, forward is designated as Fr, rearward is designated as Rr, a left side is designated as L, a right side is designated as R, upward is designated as U, and downward is designated as D.

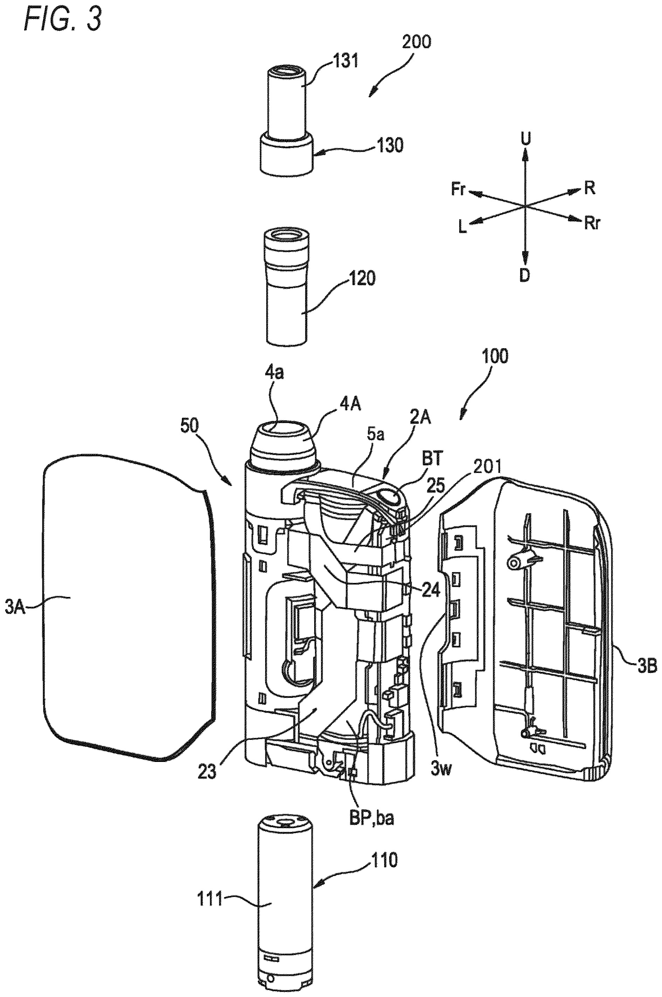

Also referring to Fig. 3, the aerosol generating device 200 includes a power supply unit 100, a first cartridge 110, and a second cartridge 120. The first cartridge 110 and the second cartridge 120 are detachable from the power supply unit 100. In other words, the first cartridge 110 and the second cartridge 120 are each replaceable.

### (Power Supply Unit)

The power supply unit 100 includes an internal unit 2A and a case 3a, and at least a part of the internal unit 2A is housed in the case 3a.

The case 3a includes a first case 3A and a second case 3B that are detachable in the left-right direction (a thickness direction), and forms a front surface, a rear surface, a left surface, and a right surface of the power supply unit 100 by assembling the first case 3A and the second case 3B in the left-right direction (the thickness direction). Specifically, the first case 3A is supported on a left side surface of a chassis 50 described later and included in the internal unit 2A, and the second case 3B is supported on a right side surface of the chassis 50, so that the internal unit 2A is housed in the case 3. A capsule holder 4A is provided forward on an upper surface of the power supply unit 100. The capsule holder 4A is provided with an opening 4a that opens upward. The capsule holder 4A is configured such that the second cartridge 120 can be inserted through the opening 4a. A mouthpiece 130 is detachably provided on the second cartridge 120.

The upper surface of the power supply unit 100 is formed by an organic light-emitting diode (OLED) cover 5a disposed behind the opening 4a, and a lower surface of the power supply unit 100 is formed by a rotatable lower lid 7a and a lower cover 8a provided with a charging terminal 1.

An inclined surface that is inclined downward and rearward is provided between the upper surface and the rear surface of the power supply unit 100. The inclined surface is provided with an operation portion that can be operated by a user. The operation portion of the present embodiment is a button type switch BT, but may be implemented by a touch panel or the like. The operation portion is used to start/shutdown/operate a micro controller unit (MCU) 6 described later and various sensors to reflect an intention of use of the user.

The charging terminal 1 accessible from the lower cover 8a is configured to be electrically connected to an external power supply (not shown) capable of supplying to the power supply unit 100 power for charging a power supply ba included in a battery pack BP. The charging terminal 1 is, for example, a receptacle into which a mating plug can be inserted. A receptacle into which various USB terminals or the like can be inserted can be used as the charging terminal 1. As an example in the present embodiment, the charging terminal 1 is a USB Type-C receptacle.

The charging terminal 1 may include, for example, a power receiving coil, and may be configured to wirelessly receive power transmitted from an external power supply. A method for power transfer in this case (wireless power transfer) may be of an electromagnetic induction type, a magnetic resonance type, or a combination of the electromagnetic induction type and the magnetic resonance type. As another example, the charging terminal 1 may be connectable to various USB terminals and the like, and may have the power receiving coil as described above.

As shown in Figs. 3 to 6, the internal unit 2A includes the battery pack BP, the chassis 50, a heating portion 60, a circuit portion 70, a notification portion, and various sensors.

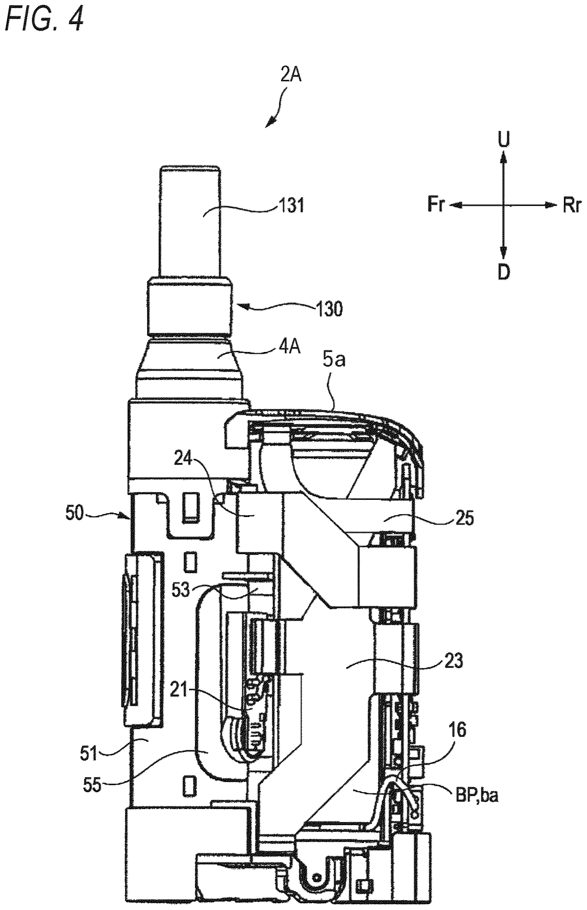

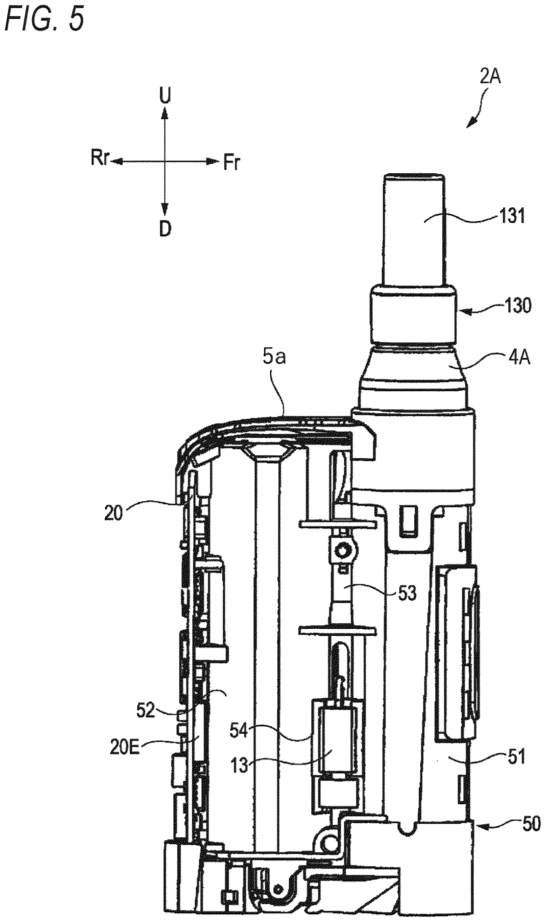

As shown in Figs. 4 and 5, the chassis 50 includes a cylindrical cartridge holding portion 51 that is located at a front part, a semi-cylindrical battery holding portion 52 that is located at a rear part and has a notch on a left side, a plate-shaped connecting portion 53 that connects the cartridge holding portion 51 and the battery holding portion 52, a motor holding portion 54 that is provided below and to a right side of the connecting portion 53 and straddles the cartridge holding portion 51 and the battery holding portion 52, and a sensor holding portion 55 that is provided to a left rear side of the cartridge holding portion 51.

The first cartridge 110 is inserted into the cartridge holding portion 51 from below with the lower lid 7a opened. The first cartridge 110 is housed in the cartridge holding portion 51 by closing the lower lid 7a with the first cartridge 110 inserted. The capsule holder 4A is attached to an upper portion of the cartridge holding portion 51. The cartridge holding portion 51 is provided with a longitudinally long through hole in a front part, and a remaining amount of an aerosol source in the first cartridge 110 and light from an light emitting diode (LED) 21D described later can be visually observed from a remaining amount confirmation window 3w provided at a joining portion of the first case 3A and the second case 3B. The first cartridge 110 will be described later.

The battery pack BP is disposed in the battery holding portion 52. The battery pack BP includes the power supply ba and a power supply thermistor for detecting a temperature of the power supply ba. The power supply ba is a chargeable secondary battery or a chargeable electric double layer capacitor, and is preferably a lithium ion secondary battery. An electrolyte of the power supply ba may be implemented by one or a combination of a gel electrolyte, an electrolyte solution, a solid electrolyte, and an ionic liquid.

The motor holding portion 54 is provided with a vibration motor 13. The sensor holding portion 55 is provided with an inhalation sensor 15 described later and performing an output corresponding to an inhalation operation (a puff operation) of the user.

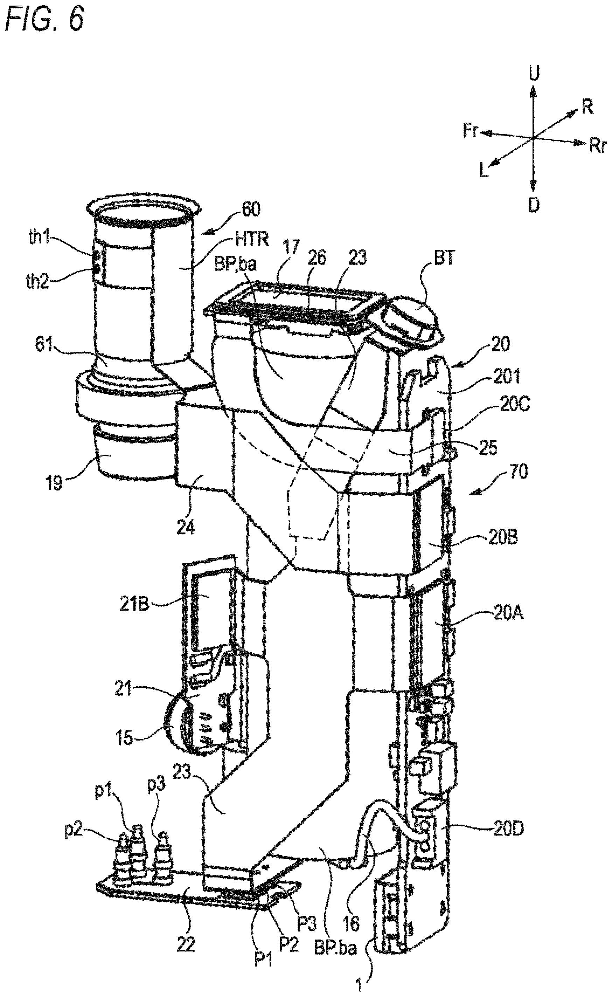

As shown in Fig. 6, the heating portion 60 includes a cylindrical heat transfer tube 61 and a seat heater HTR wound around an outer circumference of the heat transfer tube 61. The capsule holder 4A described above is provided around and spaced from the seat heater HTR. An air layer between the capsule holder 4A and the seat heater HTR functions as a heat insulator. A lower portion of the second cartridge 120 inserted through the opening 4a of the capsule holder 4A is housed in the heat transfer tube 61, and the lower portion of the second cartridge 120 is heated by the seat heater HTR. Accordingly, compared with a case where the heating portion 60 is not provided, a flavor source stored in the second cartridge 120 is more likely to release a flavor, and thus, the flavor is more likely to be added to the aerosol.

The heating portion 60 may be any element that can heat the second cartridge 120. Examples of the element include a resistance heating element, a ceramic heater, and an induction heater. As the resistance heating element, for example, a heater having a positive temperature coefficient (PTC) characteristic in which a resistance value increases as a temperature increases is used. Alternatively, a heater having a negative temperature coefficient (NTC) characteristic in which a resistance value decreases as a temperature increases may be used. The heating portion 60 has a function of defining a flow path for air to be supplied to the second cartridge 120 and a function of heating the second cartridge 120.

The notification portion notifies various kinds of information, such as a state of charge of the power supply ba, a remaining amount in the first cartridge 110, and a remaining amount in the second cartridge 120. The notification portion according to the present embodiment includes the LED 21D and the vibration motor 13. The notification portion may be implemented by a light emitting element such as the LED 21D, may be implemented by a vibration element such as the vibration motor 13, or may be implemented by a sound output element. The notification portion may be a combination of two or more elements selected from the light emitting element, the vibration element, and the sound output element.

The various sensors include the inhalation sensor 15 that detects the puff operation (the inhalation operation) of the user, a heater temperature sensor that detects a temperature of the seat heater HTR, and the like.

The inhalation sensor 15 may be implemented by, for example, a capacitor microphone, a pressure sensor, or a flow rate sensor. A plurality of inhalation sensors 15 may be disposed spaced from each other, and the puff operation may be detected from a difference between output values of these inhalation sensors. The heater temperature sensor includes a first thermistor th1 and a second thermistor th2. The first thermistor th1 and the second thermistor th2 are preferably in contact with or close to the seat heater HTR. If the seat heater HTR has the PTC characteristic or the NTC characteristic, the seat heater HTR itself may be used as the heater temperature sensor. The heater temperature sensor is implemented by two thermistors, but the heater temperature sensor may be implemented by one thermistor.

The circuit portion 70 includes four rigid circuit boards, three flexible printed circuits (FPCs, flexible printed circuit boards), a plurality of integrated circuits (ICs), and a plurality of elements. The four circuit boards include a main board 20, a puff sensor board 21, a pogo pin board 22, and an OLED board 26. The three FPCs include a main FPC 23, a heater FPC 24, and an OLED FPC 25.

The main board 20 is disposed between the battery pack BP and the rear surface of the case 3a (the rear surface of the power supply unit 100) such that an element mounting surface faces in the front-rear direction. The main board 20 is formed by stacking a plurality of boards (six boards in the present embodiment), and electronic components (elements) such as the MCU 6 and a charging IC 3 are mounted.

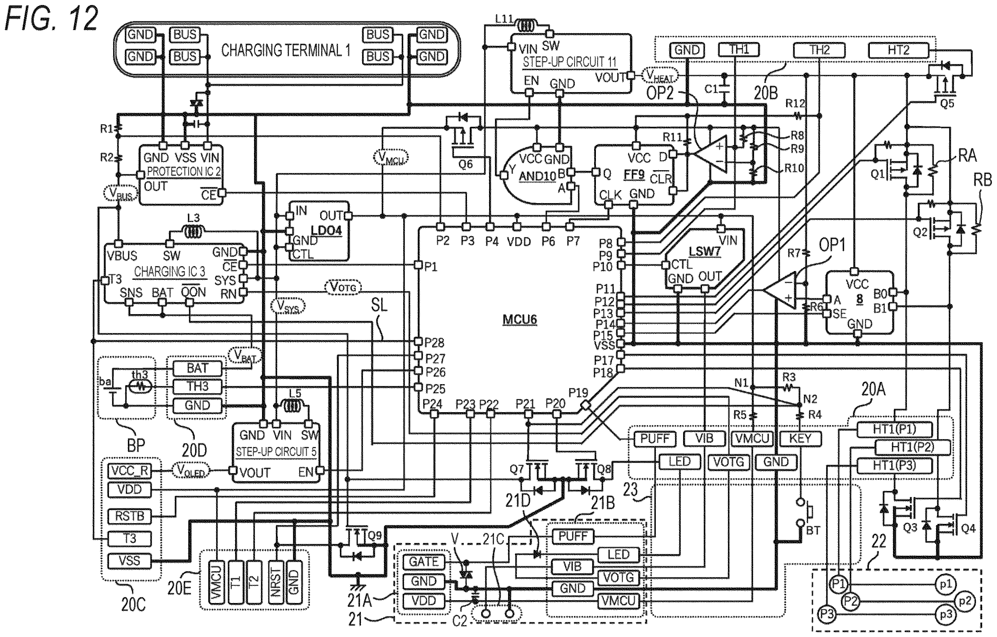

Details will be described later with reference to Fig. 12 and the like, and the MCU 6 is connected to the various sensor devices such as the inhalation sensor 15, the operation portion, the notification portion, and a memory that stores the number of times or a load of the puff operations, an energization time of the seat heater HTR, and the like, and is a control device that performs various kinds of control on the aerosol generating device 200. Specifically, the MCU 6 is implemented by a processor as a main component, and further includes a storage medium such as a random access memory (RAM) necessary for an operation of the processor and a read only memory (ROM) which stores various kinds of information. The processor in the present specification is, for example, an electrical circuit in which circuit elements such as semiconductor elements are combined. Some (for example, the inhalation sensor 15 and the memory) of the elements connected to the MCU 6 may be provided inside the MCU 6 as functions of the MCU 6 itself.

The charging IC 3 is an IC that performs charging control on the power supply ba with power input from the charging terminal 1 and supplies the power of the power supply ba to the electronic components of the main board 20 and the like.

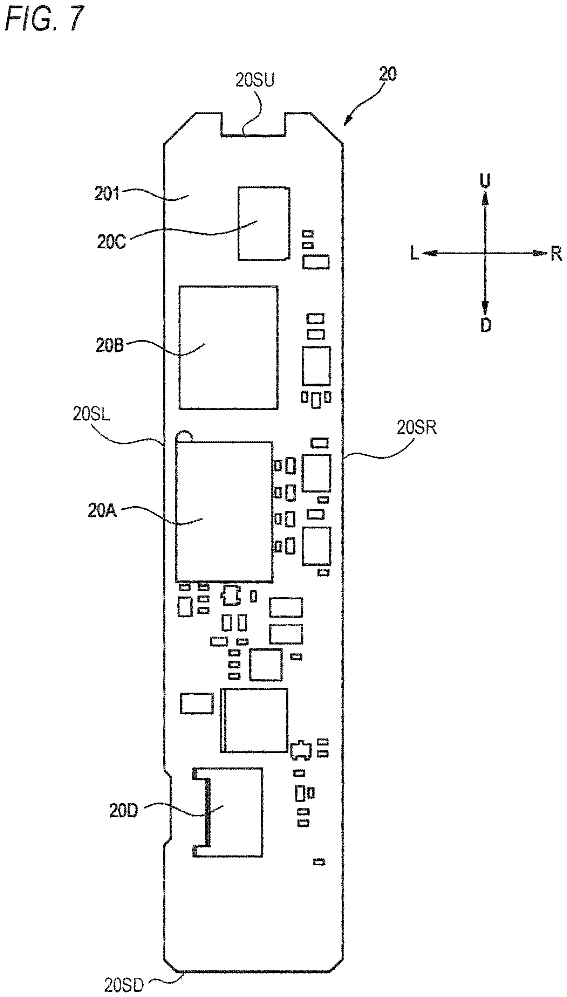

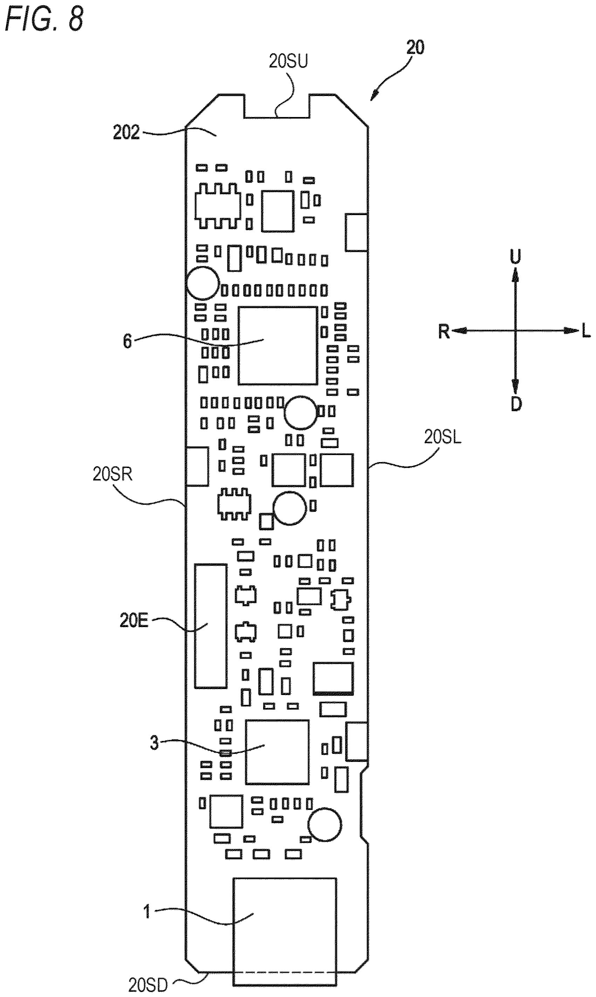

The main board 20 will be described in more detail with reference to Figs. 7 and 8. Hereinafter, a surface facing rearward of the main board 20 is referred to as a front surface 201 for convenience, and a surface facing forward of the main board 20 is referred to as a back surface 202 for convenience. Fig. 7 is a diagram showing the front surface 201 of the main board 20, and Fig. 8 is a diagram showing the back surface 202 of the main board 20. The main board 20 has a plate shape extending in the up-down direction, and in Figs. 7 and 8, an upper side surface 20SU which is a side surface at an upper side and a lower side surface 20SD which is a side surface at a lower side are shown as side surfaces orthogonal to a longitudinal direction of the main board 20. A left side surface 20SL which is a side surface at a left side and a right side surface 20SR which is a side surface at a right side are shown as side surfaces orthogonal to a lateral direction of the main board 20.

As shown in Fig. 8, the MCU 6 and the charging IC 3 are mounted on the back surface 202 of the main board 20 together with the charging terminal 1. A debugging connector 20E is further mounted on the back surface 202. The debugging connector 20E is an interface for rewriting a program of the MCU 6 by an external device such as a personal computer, and for example, one in accordance with a serial wire debug (SWD) standard is used. On the other hand, as shown in Fig. 7, an OLED connector 20C, a heater connector 20B, a main connector 20A, and a battery connector 20D connected to the battery pack BP via a lead wire 16 (see Fig. 6) are mounted on the front surface 201 of the main board 20.

As shown in Figs. 4 and 6, the puff sensor board 21 is disposed on the sensor holding portion 55 of the chassis 50 such that the element mounting surface faces right forward and left rearward. The inhalation sensor 15 is mounted on the puff sensor board 21.

As shown in Fig. 6, the OLED board 26 is disposed between the battery pack BP and the OLED cover 5a such that the element mounting surface faces in the up-down direction. An OLED panel 17 is mounted on the OLED board 26.

As shown in Fig. 6, the pogo pin board 22 is disposed on the lower lid 7a such that the element mounting surface faces in the up-down direction with the lower lid 7a closed. The pogo pin board 22 is provided with input side contact points P1 to P3 to which power is supplied from the main board 20 via the main FPC 23, and pogo pins p1 to p3 which are connectors electrically connected to loads provided in the first cartridge 110. The input side contact points P1 to P3 are electrically connected to the main FPC 23 only with the lower lid 7a closed. The three pogo pins p1 to p3 are provided at equal intervals in a circumferential direction, and are configured such that at least two pogo pins are electrically connected to a + terminal and a - terminal of the first cartridge 110 housed in the cartridge holding portion 51.

The battery pack BP held by the battery holding portion 52 at a left side of the semi-cylindrical battery holding portion 52 is exposed from the battery holding portion 52. As shown in Figs. 3, 4, and 6, the main FPC 23, the heater FPC 24, and the OLED FPC 25 are disposed so as to overlap each other in a space between the left side of the battery pack BP and the first case 3A, which is formed by cutting out the battery holding portion 52.

Among the three FPCs, the main FPC 23 is routed closest to the battery pack BP, the OLED FPC 25 is routed in a manner of partially overlapping the main FPC 23, and the heater FPC 24 is routed in a manner of overlapping the OLED FPC 25. That is, among the three FPCs, the heater FPC 24 to which largest power is supplied is routed farthest from the battery pack BP. A developed shape of the main FPC 23 is a substantially cross shape, and the main FPC 23 is folded rearward at a portion overlapping the heater FPC 24. That is, the main FPC 23 is a folded wire obtained by folding. A folded portion of the main FPC 23 tends to float in the left-right direction, but the heater FPC 24 and the OLED FPC 25 overlap this portion, thereby preventing such floatation. The switch BT is directly mounted on the main FPC 23 without a rigid board or the like.

The OLED FPC 25 has one end connected to the OLED connector 20C of the main board 20 and the other end connected to the OLED board 26.

The main FPC 23 connects the main connector 20A of the main board 20, the switch BT of the operation portion, a connector 21B of the puff sensor board 21, and the input side contact points P 1 to P3 of the pogo pin board 22.

The heater FPC 24 has one end connected to the heater connector 20B of the main board 20, and the seat heater HTR is integrally formed at the other end.

### (First Cartridge)

The first cartridge 110 includes, in a cylindrical cartridge case 111, a reservoir that stores the aerosol source, an electrical load that atomizes the aerosol source, a wick that draws the aerosol source from the reservoir to the load, and an aerosol flow path through which the aerosol generated by atomizing the aerosol source flows toward the second cartridge 120. The aerosol source contains a liquid such as glycerin, propylene glycol, or water.

The load is a heating element that heats the aerosol source without combustion by power supplied from the power supply ba via the pogo pins p1 to p3 of the pogo pin board 22, and is implemented by, for example, a heating wire (coil) wound at a predetermined pitch. The load atomizes the aerosol source by heating the aerosol source. A heating resistor, a ceramic heater, an induction heater, or the like can be used as the load. Hereinafter, the load provided on the first cartridge 110 is also referred to as a liquid heater.

The aerosol flow path is connected to the second cartridge 120 via the flow path forming body 19 (see Fig. 6) housed in the cartridge holding portion 51 of the chassis 50.

### (Second Cartridge)

The second cartridge 120 stores the flavor source. The second cartridge 120 is heated by the seat heater HTR, so that the flavor source is heated. The aerosol generated by atomizing the aerosol source by the liquid heater passes through the flavor source, so that the second cartridge 120 adds a flavor to the aerosol. As a raw material piece constituting the flavor source, shredded tobacco or a molded body obtained by molding tobacco raw materials into granules can be used. The flavor source may be implemented by plants other than tobacco (for example, mint, Chinese medicine, or herb) instead. Perfume such as menthol may be added to the flavor source.

The aerosol generating device 200 can generate the aerosol added with the flavor by the aerosol source and the flavor source. That is, the aerosol source and the flavor source constitute an aerosol generating source that generates an aerosol added with a flavor.

The aerosol generating source in the aerosol generating device 200 is a portion replaced and used by the user. Regarding this portion, for example, one first cartridge 110 and one or more (for example, five) second cartridges 120 are provided to the user as one set. The battery pack BP can be repeatedly charged and discharged as long as the power supply ba does not deteriorate significantly. Therefore, in the aerosol generating device 200, a frequency of replacement of the power supply unit 100 or the battery pack BP is the lowest, a frequency of replacement of the first cartridge 110 is the second lowest, and a frequency of replacement of the second cartridge 120 is the highest. The first cartridge 110 and the second cartridge 120 may be integrated into one cartridge. A configuration or the like in which a drug or the like instead of the flavor source is added to the aerosol source may be used.

In the aerosol generating device 200 configured in this way, air that flows from an air intake port (not shown) provided in the case 3a or the internal unit 2A passes near the load of the first cartridge 110. The load atomizes the aerosol source drawn from the reservoir by the wick. The aerosol generated by atomization flows through the aerosol flow path together with the air that flows from the intake port, and is supplied to the second cartridge 120 via the flow path forming body 19. The aerosol supplied to the second cartridge 120 is added with the flavor by passing through the flavor source, and is supplied to an inhalation port 131 of the mouthpiece 130.

Details of the connectors mounted on the main board 20 supported by the chassis 50 will be described below.

A connector of the main FPC 23, a connector of the heater FPC 24, a connector of the OLED FPC 25, and the lead wire 16 are inserted in a right direction into the main connector 20A, the heater connector 20B, the OLED connector 20C, and the battery connector 20D which are mounted on the front surface 201 of the main board 20 shown in Fig. 7, respectively. Inserting to the right direction refers to inserting from left to right. The connector of the main FPC 23, the connector of the heater FPC 24, the connector of the OLED FPC 25, and the lead wire 16 are respectively routed to a battery pack BP side from positions of the connectors to be inserted across the left side surface 20SL of the main board 20. A connector of a connection cable (not shown) is inserted in a left direction into the debugging connector 20E which is mounted on the back surface 202 of the main board 20 shown in Fig. 8. Inserting to the left direction refers to inserting from right to left. A connector of a USB cable (not shown) is inserted in an up direction into the charging terminal 1 which is mounted on the back surface 202 of the main board 20. Inserting to the up direction refers to inserting from down to up.

In this way, on the main board 20, the four connectors (the OLED connector 20C, the heater connector 20B, the main connector 20A, and the battery connector 20D) to which the wires (the FPCs or the lead wire) are always connected, and the debugging connector 20E and the charging terminal 1 to which the wire (the connection cable or the USB cable) is connected only when necessary are mounted on different element mounting surfaces. Therefore, the wires connected to the above four connectors are easily routed. In particular, as described above, by making insertion directions of the wires with respect to the above four connectors the same, the wire routing becomes easier, and a design such as reduction of a surplus space becomes easier, and thus, the power supply unit 100 can be miniaturized.

The insertion directions of the wires with respect to the four connectors which are mounted on the front surface 201 are common to the right direction. On the other hand, an insertion direction of the wire with respect to the debugging connector 20E which is mounted on the back surface 202 is a direction different from (specifically, a direction opposite to) the directions with respect to the above four connectors. Accordingly, when the connection cable is inserted into the debugging connector 20E, it is possible to prevent this connection cable from interfering with the wires inserted into the four connectors. An insertion direction of the wire with respect to the charging terminal 1 is different from the insertion direction of the wire with respect to the debugging connector 20E (specifically, a direction orthogonal to the insertion direction thereof). Accordingly, even when the connection cable is inserted into the debugging connector 20E and the USB cable is connected to the charging terminal 1, an interference between these two cables can be prevented.

By removing only the second case 3B of the case 3a from the chassis 50, the debugging connector 20E can be inserted to and removed from the connection cable. In other words, the debugging connector 20E also allows the connection cable to be inserted and removed with the first case 3A of the cases 3a still attached. When only the second case 3B of the case 3a is removed from the chassis 50 (with the first case 3A still attached), the above four connectors and the wires connected to the four connectors are not exposed. As a result, it is possible to prevent a person from touching the four connectors on the front surface 201 and the wires connected to the four connectors when inserting or removing the connection cable to or from the debugging connector 20E.

As shown in Fig. 3, the front surface 201 of the main board 20 faces a side opposite to the battery pack BP side. In other words, a distance between the front surface 201 of the main board 20 and the rear surface of the case 3a is smaller than a distance between the back surface 202 of the main board 20 and the front surface of the case 3a. Further, no other components constituting the internal unit 2A are present between the front surface 201 of the main board 20 and an inner wall of the case 3a (the rear surface of the case 3a) facing this front surface 201. Accordingly, the distance between the front surface 201 and the case 3a is minimized, and the power supply unit 100 is further miniaturized.

Next, details of a holding mechanism of the inhalation sensor 15 in the case 3a will be described.

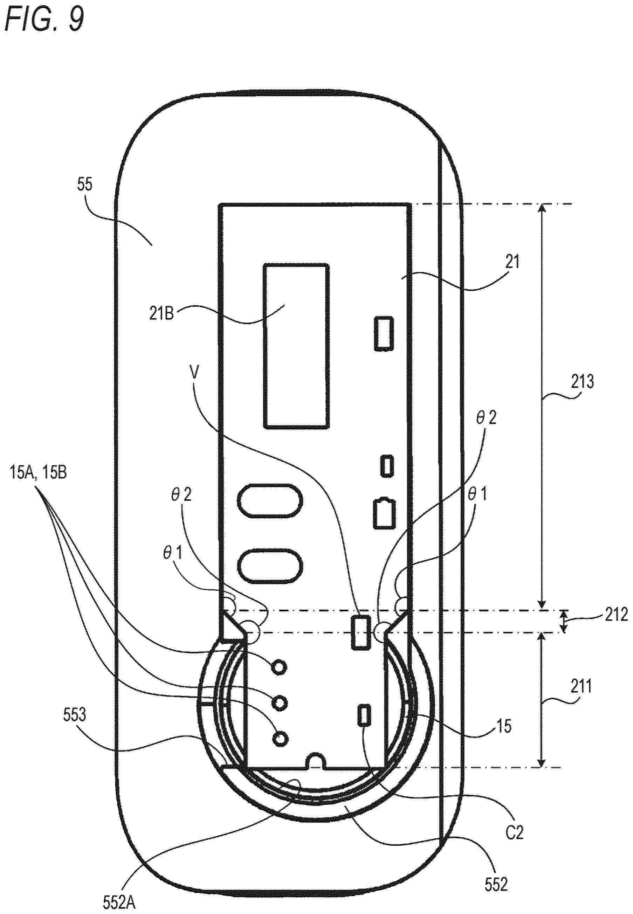

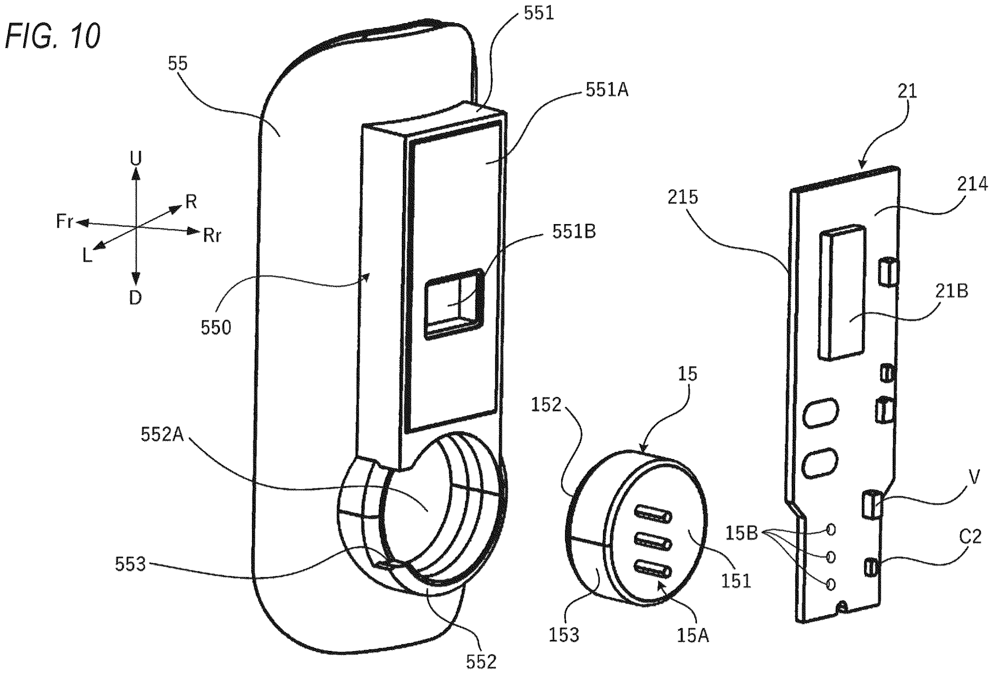

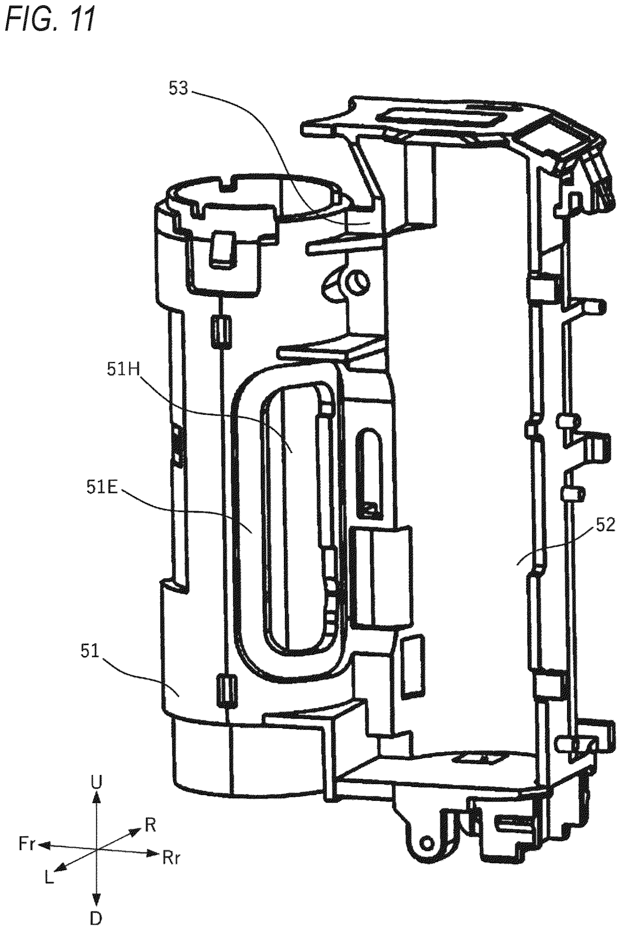

Figs. 9 and 10 are diagrams showing detailed configurations of the puff sensor board 21 and the sensor holding portion 55. Fig. 9 is a plan view seen in a direction perpendicular to the element mounting surface of the puff sensor board 21 (in other words, a thickness direction of the puff sensor board 21). Fig. 10 is an exploded perspective view of the puff sensor board 21, the sensor holding portion 55, and the inhalation sensor 15 shown in Fig. 9. Fig. 11 is a perspective view of the chassis 50 with the sensor holding portion 55 removed.

As shown in Fig. 10, the inhalation sensor 15 has a substantially cylindrical outer shape, and includes a fixed electrode 151 disposed at one end in an axial direction, a movable electrode 152 disposed at the other end in the axial direction and movable in the axial direction with respect to the fixed electrode 151, and a ring-shaped side surface 153. A terminal group 15A including an output terminal, a ground terminal, and a power supply terminal of the inhalation sensor 15 protrudes from a surface on a fixed electrode 151 side of the inhalation sensor 15.

As shown in Figs. 9 and 10, the puff sensor board 21 has a plate shape extending in the up-down direction. Hereinafter, a surface of the puff sensor board 21 on a side opposite to a sensor holding portion 55 side is referred to as a front surface 214 for convenience, and a surface of the puff sensor board 21 on the sensor holding portion 55 side is referred to as a back surface 215 for convenience. A length of the puff sensor board 21 in the lateral direction is referred to as a width.

As shown in Fig. 9, the puff sensor board 21 includes a first portion 211 disposed at one end (a lower end) in the longitudinal direction and having a narrowest width, a third portion 213 spaced above the first portion 211 and having a widest width, and a second portion 212 connecting the first portion 211 and the third portion 213. A width of the second portion 212 widens from the first portion 211 toward the third portion 213 and is wider than the width of the first portion 211 and narrower than the width of the third portion 213. Since the width of the puff sensor board 21 is gradually changed by the second portion 212, a conductive pattern passing near an edge of the puff sensor board 21 does not have a curve with an acute angle at a portion where the width changes. Accordingly, a parasitic resistance and a parasitic inductance of the conductive pattern are reduced, and heat and noise that may occur on the puff sensor board 21 are reduced. More specifically, in the plan view of Fig. 9, angles θ1 of vertexes formed by the third portion 213 and the second portion 212 are 90 degrees or more, angles θ2 of vertexes formed by the second portion 212 and the first portion 211 are 90 degrees or more, so that it becomes easy to provide the conductive pattern along the angles, and it is possible to prevent the conductive pattern from forming an acute angle.

The inhalation sensor 15 is mounted on the back surface 215 of the first portion 211. The first portion 211 is formed with three through holes 15B penetrating in the thickness direction. The terminal group 15A of the inhalation sensor 15 is inserted through the through holes 15B from a back surface 215 side. The puff sensor board 21 is provided with a puff sensor connector 21A which is electrically connected to the connector 21B and described later, and the terminal group 15A of the inhalation sensor 15 inserted through the through holes 15B is electrically connected to the puff sensor connector 21A. An output signal of the inhalation sensor 15 is input to the MCU 6 via the puff sensor connector 21A, the connector 21B, and the main FPC 23 connected to the connector 21B. As shown in Fig. 9, the width of the first portion 211 is small enough to allow the inhalation sensor 15 to protrude outward. That is, the inhalation sensor 15 has a portion projecting outward from the puff sensor board 21. A width of the inhalation sensor 15 is the same as the width of the third portion 213. The width of the inhalation sensor 15 may be smaller than the width of the third portion 213. By making the width of the third portion 213 equal to or greater than the width of the inhalation sensor 15 in this way, more electronic components can be mounted on the puff sensor board 21.

As shown in Fig. 11, an opening 51H is formed in a left rear side surface of the cartridge holding portion 51 which defines a substantially cylindrical cavity housing the first cartridge 110. A peripheral edge portion 51E of the opening 51H is slightly recessed, the sensor holding portion 55 is fixed to the peripheral edge portion 51E with an adhesive or the like, and the opening 51H is closed by the sensor holding portion 55.

The sensor holding portion 55 has a curved shape corresponding to a curved shape of an outer peripheral surface of the substantially cylindrical cartridge holding portion 51. That is, when viewed from above, the sensor holding portion 55 has a shape along a circumferential direction of the cartridge holding portion 51. By forming the sensor holding portion 55 into such a curved shape, a region inside the case 3a can be effectively utilized, and the power supply unit 100 can be miniaturized.

As shown in Fig. 10, the sensor holding portion 55 has a protruding portion 550 that protrudes left rearward and extends in the up-down direction. The protruding portion 550 includes an upper portion 551 having a flat surface 551A formed with a recess portion 551B, and a substantially annular lower portion 552 disposed below the upper portion 551. An inner diameter of a through hole 552A formed in the lower portion 552 is substantially equal to an outer diameter of the inhalation sensor 15.

When the inhalation sensor 15 mounted on the puff sensor board 21 is press-fitted into the through hole 552A, an inner peripheral surface of the lower portion 552 and the side surface 153 of the inhalation sensor 15 are in contact with each other, and as shown in Fig. 9, the inhalation sensor 15 and the puff sensor board 21 are supported by the sensor holding portion 55. In a state shown in Fig. 9, since the movable electrode 152 faces the cartridge holding portion 51, the inhalation sensor 15 can detect a pressure fluctuation in an internal space of the cartridge holding portion 51. When the user performs inhalation, the pressure fluctuation occurs in the internal space, so that the inhalation of the user can be detected by the inhalation sensor 15. In the state shown in Fig. 9, the LED 21D mounted on the back surface 215 of the puff sensor board 21 faces the recess portion 551B of the sensor holding portion 55. The sensor holding portion 55 or the recess portion 551B is made of a material having optical transparency, and light from the LED 21D illuminates the aerosol source in the first cartridge 110 housed in the cartridge holding portion 51 through the opening 51H of the cartridge holding portion 51. Accordingly, the user can easily visually observe the remaining amount of the aerosol source in the first cartridge 110 through the remaining amount confirmation window 3w.

As described above, the side surface 153 of the inhalation sensor 15 has a portion projecting outward from the puff sensor board 21. Therefore, after the inhalation sensor 15 is mounted on the puff sensor board 21, the side surface 153 can be gripped and the inhalation sensor 15 can be easily press-fitted into the through hole 552A. Accordingly, when the power supply unit 100 is manufactured, a risk of touching sensitive components such as the movable electrode 152 and the fixed electrode 151 of the inhalation sensor 15 with a finger or the like is reduced, and a failure in the inhalation sensor 15 can be prevented.

As shown in Figs. 9 and 10, the lower portion 552 of the sensor holding portion 55 is provided with a notch 553 in a part of the peripheral edge portion. The notch 553 is provided, so that in a process of press-fitting the inhalation sensor 15 into the through hole 552A, it becomes easier to maintain a state where the side surface 153 of the inhalation sensor 15 is gripped. Therefore, the inhalation sensor 15 can be easily press-fitted into the sensor holding portion 55.

The notch 533 of the sensor holding portion 55 is exposed to the outside with the first case 3A of the cases 3a removed from the chassis 50 as shown in Fig. 4. Therefore, maintenance of the inhalation sensor 15 and an attachment operation to the sensor holding portion55 can be facilitated compared with a configuration in which the notch 533 is not exposed to the outside with the case 3a removed from the chassis 50.

The sensor holding portion 55 is disposed such that a radial direction of the through hole 552A (a direction along a plane orthogonal to an extending direction of the through hole 552A) intersects with two directions (in an example in the drawing, the lateral direction and the thickness direction) of the longitudinal direction (the up-down direction), the lateral direction (the front-rear direction), and the thickness direction (the left-right direction) of the power supply unit 100. For example, assuming a case where the sensor holding portion 55 is fixed to the rear surface of the cartridge holding portion 51 such that the lateral direction is aligned with the left-right direction and the longitudinal direction is aligned with the up-down direction, although the front-rear direction intersects with the radial direction of the through hole 552A, both the up-down direction and the thickness direction are parallel to the radial direction of the through hole 552A. In such a configuration, a thickness (a length in the left-right direction) and a width (a length in the front-rear direction) of the internal unit 2A are increased. In this regard, according to the configuration of the present embodiment in which the sensor holding portion 55 is fixed to an oblique left rear surface of the cartridge holding portion 51, the thickness and the width of the internal unit 2A can be reduced, and thus, the power supply unit 100 can be miniaturized.

For example, it is assumed that a shape of the aerosol generating device 200 is an elongated cylinder as a whole, and the capsule holder 4A, the cartridge holding portion 51, and the battery pack BP are arranged in a straight line. In this case, for example, assuming a case where the sensor holding portion 55 is fixed to a left surface of the cartridge holding portion 51 such that the lateral direction is aligned with the front-rear direction and the longitudinal direction is aligned with the up-down direction, although the thickness direction intersects with the radial direction of the through hole 552A, both the up-down direction and the front-rear direction are parallel to the radial direction of the through hole 552A. In such a configuration, the thickness and the width of the internal unit 2A are increased. In this regard, according to the configuration of the present embodiment in which the sensor holding portion 55 is fixed to an oblique left rear surface of the cartridge holding portion 51, the thickness and the width of the internal unit 2A can be reduced, and thus, the power supply unit 100 can be miniaturized.

The connector 21B electrically connected to the puff sensor connector 21A and a vibration motor connector 21C described later, a varistor V as a protective component that protects the MCU 6 or other electrical components mounted on the puff sensor board 21 from a signal output from the output terminal of the inhalation sensor 15, and a capacitor C2 as a protective component that protects the inhalation sensor 15 from power input to the power supply terminal of the inhalation sensor 15 are mounted on the front surface 214 of the puff sensor board 21. An IC other than the inhalation sensor 15 is not mounted on the puff sensor board 21. In this way, since the puff sensor board 21 does not have an IC other than the inhalation sensor 15 that can be a generation source of noise, the inhalation sensor 15 can be stably operated.

As shown in Fig. 9, the capacitor C2 is mounted on the first portion 211. The varistor V is mounted across the first portion 211 and the second portion 212. In this way, the capacitor C2 and the varistor V are mounted at positions near the terminal group 15A of the inhalation sensor 15 when viewed in the thickness direction of the puff sensor board 21, so that the noise input to the inhalation sensor 15 or output from the inhalation sensor 15 can be quickly processed by the protective component.

As described above, the inhalation sensor 15 supported by the chassis 50 in the case 3a is not exposed to the outside when the first case 3A is not removed from the chassis 50. In other words, the inhalation sensor 15 is exposed to the outside only when the first case 3A is removed from the chassis 50. For example, when only the second case 3B is removed from the chassis 50 and the debugging connector 20E is used, the inhalation sensor 15 is not exposed to the outside, so that the inhalation sensor 15 is less likely to fail.

### (Circuit Configuration)

Fig. 12 is a diagram showing a schematic configuration of a circuit provided on the main board 20. In addition to the circuit of the main board 20, Fig. 12 shows the main FPC 23 connected to the main connector 20A of the main board 20, the puff sensor board 21 connected to the main FPC 23, the pogo pin board 22 connected to the main FPC 23, and the battery pack BP connected to the battery connector 20D.

A wire indicated by a thick solid line in Fig. 12 is a wire that has the same potential as reference potential (ground potential, hereinafter set as 0 V as an example) of the power supply unit 100 (a wire connected to the ground provided in the power supply unit 100), and the wire is hereinafter referred to as a ground line.

The main board 20 is provided with, as main ICs which are electronic components in which a plurality of circuit elements are formed into a chip, a protection IC 2, the charging IC 3, a low dropout (LDO) regulator (hereinafter, referred to as LDO) 4, a step-up circuit 5 including a DC/DC converter, the MCU 6, a load switch (hereinafter, referred to as LSW) 7 configured by combining a capacitor, a resistor, a transistor, and the like, a multiplexer 8, a flip-flop (hereinafter, referred to as FF) 9, an AND gate (simply described as "AND" in Fig. 12) 10, a step-up circuit 11 including a DC/DC converter, an operational amplifier OP1, and an operational amplifier OP2.

The main board 20 is further provided with switches Q1 to Q9 implemented by metal-oxide-semiconductor field-effect transistors (MOSFETs), resistors R1 to R12, RA, and RB having fixed electrical resistance values, a capacitor C1, the capacitor C2, the varistor V, a reactor L3 connected to the charging IC 3, a reactor L5 connected to the step-up circuit 5, and a reactor L11 connected to the step-up circuit 11. Each of the switch Q3, the switch Q4, the switch Q7, the switch Q8, and the switch Q9 is implemented by an N-channel MOSFET. Each of the switch Q1, the switch Q2, the switch Q5, and the switch Q6 is implemented by a P-channel MOSFET. Each of the switches Q1 to Q8 is switched between an ON state and an OFF state by controlling potential of a gate terminal by the MCU 6.

In Fig. 12, symbols of various terminals are described for each IC except the operational amplifiers. A terminal VCC and a terminal VDD mounted on the chip indicate power supply terminals on a high potential side, respectively. A terminal VSS and a terminal GND mounted on the chip indicate power supply terminals on a low potential side (a reference potential side), respectively. In the electronic component formed into a chip, a difference between potential of the power supply terminal on the high potential side and potential of the power supply terminal on the low potential side is a power supply voltage (an operation voltage). The electronic component formed into a chip executes various functions by using the power supply voltage.

In Fig. 12, the terminal GND and terminal VSS of each IC except the operational amplifiers are connected to the ground line. Terminals GND of the charging terminal 1, a negative power supply terminal of the operational amplifier OP1, and a negative power supply terminal of the operational amplifier OP2 are connected to the ground line.

The battery connector 20D (see near left center in Fig. 12) provided on the main board 20 includes a terminal BAT connected to a detection terminal SNS of the charging IC 3 and a charging terminal BAT of the charging IC 3, a terminal GND connected to the ground line of the main board 20, and a terminal TH3 connected to a terminal P25 of the MCU 6. The terminal BAT of the battery connector 20D is connected by the lead wire 16 to a positive electrode side terminal of the power supply ba included in the battery pack BP. The terminal TH3 of the battery connector 20D is connected by the lead wire 16 to a positive electrode side terminal of a power supply thermistor th3 included in the battery pack BP. The terminal GND of the battery connector 20D is connected by the lead wire 16 to a negative electrode side terminal of the power supply ba and a negative electrode side terminal of the power supply thermistor th3.

The OLED connector 20C (see near the lower left in Fig. 12) provided on the main board 20 includes a terminal VCC_R connected to an output terminal VOUT of the step-up circuit 5, a terminal VDD connected to an output terminal OUT of the LDO 4, a terminal RSTB connected to a terminal P24 of the MCU 6, a communication terminal T3 connected to a communication terminal P28 of the MCU 6 through a signal line SL, and a terminal VSS connected to the ground line of the main board 20.

The terminal VCC_R of the OLED connector 20C is connected to a drive voltage supply terminal of the OLED panel 17 by the OLED FPC 25. The terminal VDD of the OLED connector 20C is connected to a power supply terminal of a control IC controlling the OLED panel 17 by the OLED FPC 25. A voltage to be supplied to the drive voltage supply terminal of the OLED panel 17 is, for example, about 15 V, and is larger than a voltage to be supplied to the power supply terminal of the control IC of the OLED panel 17. The terminal VSS of the OLED connector 20C is connected to ground terminals of the OLED panel 17 and the control IC of the OLED panel 17 by the OLED FPC 25. The terminal RSTB of the OLED connector 20C is connected to a terminal for restarting in the control IC of the OLED panel 17 by the OLED FPC 25.

The signal line SL connected to the communication terminal T3 of the OLED connector 20C is also connected to a communication terminal T3 of the charging IC 3. The signal line SL allows the MCU 6 to communicate with the charging IC 3 and communicate with the control IC of the OLED panel 17. The signal line SL is for serial communication, and actually requires a plurality of signal lines such as a data line for data transmission and a clock line for synchronization. It should be noted that the signal line SL is shown as one data line in Fig. 12 for the sake of simplification. Communication between the MCU 6 and the charging IC 3 and the control IC of the OLED panel 17 may be performed by parallel communication instead of the serial communication.

The debugging connector 20E (see near the lower left in Fig. 12) provided on the main board 20 includes a terminal VMCU connected to the output terminal OUT of the LDO 4, a terminal T1 (there is one terminal in the drawing, but there are actually two terminals) connected to a communication terminal P23 of the MCU 6, a terminal T2 (there is one terminal in the drawing, but there are actually two terminals) connected to a communication terminal P22 of the MCU 6, a terminal NRST connected to a terminal P27 of the MCU 6, and a terminal GND connected to the ground line of the main board 20. The terminal NRST is also connected to a drain terminal of the switch Q9 whose gate terminal is connected to a drain terminal of the switch Q7 and whose source terminal is connected to the ground line. The debugging connector 20E is not used in a normal using state of the aerosol generating device 200, and is used by being connected to a computer prepared by a manufacturer or seller only when maintenance such as rewriting of information (including a program) stored in the MCU 6 is required.

The main connector 20A (see near the right center in Fig. 12) provided on the main board 20 is provided with a terminal PUFF connected to a terminal P19 of the MCU 6, a terminal LED connected to a drain terminal of the switch Q8 whose gate terminal is connected to a terminal P20 of the MCU 6 and whose source terminal is connected to the ground line, a terminal VIB connected to an output terminal OUT of the LSW 7, a terminal VOTG connected to a step-up output terminal RN of the charging IC 3, a terminal VMCU connected to the output terminal OUT of the LDO 4 via the resistor R5, a terminal GND connected to the ground line, a terminal KEY connected to the output terminal OUT of the LDO 4 via a voltage divider circuit including the resistor R4 and the resistor R3 connected to the resistor R4 in series, a terminal HT1 (P1) connected to a drain terminal of the switch Q1 whose gate terminal is connected to a terminal P12 of the MCU 6 and whose source terminal is connected to an output terminal VOUT of the step-up circuit 11, a terminal HT1 (P2) connected to a drain terminal of the switch Q2 whose gate terminal is connected to a terminal P13 of the MCU 6 and whose source terminal is connected to the output terminal VOUT of the step-up circuit 11, and connected to a drain terminal of the switch Q4 whose gate terminal is connected to a terminal P17 of the MCU 6 and whose source terminal is connected to the ground line, and a terminal HT1 (P3) connected to a drain terminal of the switch Q3 whose gate terminal is connected to a terminal P18 of the MCU 6 and whose source terminal is connected to the ground line.

The terminal HT1 (P1) of the main connector 20A is connected to the input side contact point P1 connected to the pogo pin p1 by the main FPC 23. The terminal HT1 (P2) of the main connector 20A is connected to the input side contact point P2 connected to the pogo pin p2 by the main FPC 23. The terminal HT1 (P3) of the main connector 20A is connected to the input side contact point P3 connected to the pogo pin p3 by the main FPC 23. The terminal KEY of the main connector 20A is connected to one end of the switch BT mounted on the main FPC 23 by the wire of the main FPC 23. The other end of the switch BT is connected to the ground line of the main FPC 23.

The heater connector 20B (see near the upper right in Fig. 12) provided on the main board 20 includes a first thermistor terminal TH1 connected via a wire of the heater FPC 24 to a positive side terminal of a first thermistor th1 mounted on the heater FPC 24, a second thermistor terminal TH2 connected via the wire of the heater FPC 24 to a positive side terminal of a second thermistor th2 mounted on the heater FPC 24, a seat heater terminal HT2 connected via the wire of the heater FPC 24 to a positive side terminal of the seat heater HTR formed by a conductive pattern of the heater FPC 24, and a terminal GND connected to the ground line of the main board 20. A wire connected to a negative side terminal of the first thermistor th1, a negative side terminal of the second thermistor th2, and a negative side terminal of the seat heater HTR is formed on the heater FPC 24, and the wire is connected to the terminal GND of the heater connector 20B. The seat heater terminal HT2 is connected to a drain terminal of the switch Q5 whose gate terminal is connected to a terminal P11 of the MCU 6 and whose source terminal is connected to the output terminal VOUT of the step-up circuit 11.

The puff sensor connector 21A connected to the terminal group 15A of the inhalation sensor 15, the connector 21B connected to the main FPC 23, the vibration motor connector 21C connected to the vibration motor 13, the LED 21D, the varistor V, and the capacitor C2 are mounted on the puff sensor board 21 (see near the bottom center in Fig. 12).

The connector 21B of the puff sensor board 21 includes terminals (a terminal PUFF, a terminal LED, a terminal VIB, a terminal VOTG, a terminal VMCU, and a terminal GND) respectively connected to the terminal PUFF, the terminal LED, the terminal VIB, the terminal VOTG, the terminal VMCU, and the terminal GND of the main connector 20A by wires formed in the main FPC 23. As described above, the main FPC 23 is provided with the switch BT connected between the terminal KEY of the main connector 20A and the ground line. When the switch BT is pressed, the terminal KEY is connected to the ground line of the main FPC 23, and potential of the terminal KEY becomes ground potential. On the other hand, when the switch BT is not pressed, the terminal KEY is disconnected from the ground line of the main FPC 23, and the potential of the terminal KEY is indefinite.

The puff sensor connector 21A of the puff sensor board 21 includes a terminal GATE connected to the output terminal of the inhalation sensor 15, a terminal GND connected to the ground terminal of the inhalation sensor 15, and a terminal VDD connected to the power supply terminal of the inhalation sensor 15. The terminal GATE of the puff sensor connector 21A is connected to the terminal PUFF of the connector 21B. The terminal VDD of the puff sensor connector 21A is connected to the terminal VMCU of the connector 21B. The terminal GND of the puff sensor connector 21A is connected to the terminal GND of the connector 21B. One end of the varistor V is connected to a connection line between the terminal GATE of the puff sensor connector 21A and the terminal PUFF of the connector 21B, and the other end of the varistor V is connected to the ground line. Even when a large voltage is input to the terminal GATE from the inhalation sensor 15 side, the varistor V can prevent the voltage from being input to other components of the puff sensor board 21 and the MCU 6. One end of the capacitor C2 is connected to a connection line between the terminal VDD of the puff sensor connector 21A and the terminal VMCU of the connector 21B, and the other end of the capacitor C2 is connected to the ground line. Even when an unstable voltage is input to the terminal VDD of the puff sensor connector 21A from the main board 20 side, the voltage smoothed by the capacitor C2 can be input to the inhalation sensor 15 by the capacitor C2.

The vibration motor connector 21C of the puff sensor board 21 includes a positive side terminal connected to the terminal VIB of the connector 21B and a negative side terminal connected to the ground line. The vibration motor 13 is connected to the positive side terminal and the negative side terminal.

The LED 21D of the puff sensor board 21 has an anode connected to the terminal VOTG of the connector 21B and a cathode connected to the terminal LED of the connector 21B.

The charging terminal 1 on the upper left in Fig. 12 includes four terminals GND and four power supply input terminals BUS. The power supply input terminals BUS of the charging terminal 1 are connected in parallel to an input terminal VIN of the protection IC 2. In a state where a USB plug is connected to the charging terminal 1 and a USB cable including this USB plug is connected to an external power supply, that is, in a state where the USB connection is established, a USB voltage V_{USB} is input to the input terminal VIN of the protection IC 2 via the power supply input terminals BUS of the charging terminal 1.

The protection IC 2 adjusts the USB voltage V_{USB} input to the input terminal VIN, and outputs a bus voltage V_{BUS} of a predetermined value (hereinafter set as 5.0 V as an example) from an output terminal OUT. The output terminal OUT of the protection IC 2 is connected in parallel with the charging IC 3, a voltage divider circuit including a series circuit of the resistor R1 and the resistor R2, and the switch Q7. Specifically, the output terminal OUT of the protection IC 2 is connected to one end of the resistor R2 forming the voltage divider circuit, an input terminal VBUS of the charging IC 3, and the drain terminal of the switch Q7 whose gate terminal is connected to a terminal P21 of the MCU 6 and whose source terminal is connected to the ground line. One end of the resistor R1 is connected to the other end of the resistor R2, and the other end of the resistor R1 is connected to the ground line. A node connecting the resistor R1 and the resistor R2 is connected to a terminal P2 of the MCU 6. The protection IC 2 outputs the bus voltage V_{BUS} from the output terminal OUT when a low-level signal is input from the MCU 6 to a negative logic enable terminal CE (⁻), and stops outputting the bus voltage V_{BUS} from the output terminal OUT when a high-level signal is input from the MCU 6 to the enable terminal CE (⁻).

The charging IC 3 has a charging function of charging the power supply ba based on the bus voltage V_{BUS} input to the input terminal VBUS. The charging IC 3 acquires a charging current and a charging voltage of the power supply ba by the detection terminal SNS, and based on the acquired charging current and charging voltage, performs charging control on the power supply ba (control on supply of power from the charging terminal BAT to the power supply ba). The charging IC 3 acquires temperature information of the power supply ba, which is acquired by the MCU 6 from the power supply thermistor th3 via the terminal P25, from the MCU 6 through the serial communication using the signal line SL, and uses the temperature information for the charging control.

The charging IC 3 has a first function of generating a system power supply voltage V_{SYS} from a voltage of the power supply ba (hereinafter, referred to as a power supply voltage V_{BAT}) input to the charging terminal BAT and outputting the system power supply voltage V_{SYS} from an output terminal SYS, a second function of generating a system power supply voltage V_{SYS} from the bus voltage V_{BUS} input to the input terminal VBUS and outputting the system power supply voltage V_{SYS} from the output terminal SYS, and a third function of outputting an OTG voltage V_{OTG} (a voltage of 5 V as an example) obtained by stepping up the power supply voltage V_{BAT} input to the charging terminal BAT from the step-up output terminal RN. The second function is enabled only when the USB connection is established. In this way, the system power supply voltage V_{SYS} and the OTG voltage V_{OTG} are in a normal state where the power supply ba can supply power to the charging IC 3, and if the charging IC 3 operates normally, an output from the charging IC 3 is always possible.

One end of the reactor L3 is connected to a switching terminal SW of the charging IC 3. The other end of the reactor L3 is connected to the output terminal SYS of charging IC 3. The charging IC 3 has a negative logic enable terminal CE (⁻), and this enable terminal CE (⁻) is connected to a terminal P1 of the MCU 6. When the USB connection is established to input a high-level signal to the terminal P2, by controlling potential of the terminal P1 to a low level, the MCU 6 permits the charging control on the power supply ba performed by the charging IC 3, and further enables the second function.

The charging IC 3 further includes a negative logic terminal QON (⁻). The terminal QON (⁻) is connected to a node N2 connecting the resistor R3 and the resistor R4, and this node N2 is connected to the terminal P21 of the MCU 6. The charging IC 3 stops the voltage output from the output terminal SYS when a low-level signal is input to the terminal QON (⁻).

The LDO 4, the step-up circuit 5, and the step-up circuit 11 are connected in parallel to the output terminal SYS of the charging IC 3. Specifically, the output terminal SYS of the charging IC 3 is connected to a control terminal CTL and an input terminal IN of the LDO 4, an input terminal VIN of the step-up circuit 5 and an input terminal VIN of the step-up circuit 11. The OTG voltage V_{OTG} output from the step-up output terminal RN of the charging IC 3 is supplied to the anode of the LED 21D via the terminal VOTG of the main connector 20A and the terminal VOTG of the connector 21B. The cathode of the LED 21D is connected to the ground via the terminal LED of the connector 21B, the terminal LED of the main connector 20A, and the switch Q8. Therefore, the MCU 6 performs on and off control on the switch Q8, thereby enabling lighting control on the LED 21D using the OTG voltage V_{OTG}.

The step-up circuit 5 includes a switching terminal SW, a positive logic enable terminal EN connected to a terminal P26 of the MCU 6, an output terminal VOUT, and a terminal GND. One end of the reactor L5 is connected to the switching terminal SW of the step-up circuit 5. The other end of the reactor L5 is connected to the input terminal VIN of the step-up circuit 5. The step-up circuit 5 performs the on and off control on a built-in transistor connected to the switching terminal SW to step up the voltage input to the switching terminal SW via the reactor L5, and outputs the stepped-up voltage from the output terminal VOUT. The OLED voltage V_{OLED} output from the output terminal VOUT of the step-up circuit 5 is a sufficiently large voltage suitable for driving the OLED panel 17, and is, for example, a voltage of 15 V The input terminal VIN of the step-up circuit 5 constitutes a power supply terminal on a high potential side of the step-up circuit 5. The step-up circuit 5 outputs the OLED voltage V_{OLED} when a signal input from the terminal P26 of the MCU 6 to the enable terminal EN is at a high level, and stops outputting the OLED voltage V_{OLED} when the signal input from the terminal P26 of the MCU 6 to the enable terminal EN is at a low level. In this way, the OLED panel 17 is driven and controlled by the MCU 6.

The step-up circuit 11 includes the input terminal VIN, a switching terminal SW, the output terminal VOUT, a positive logic enable terminal EN, and a terminal GND. One end of the reactor L11 is connected to the switching terminal SW of the step-up circuit 11. The other end of the reactor L11 is connected to the input terminal VIN of the step-up circuit 11. The step-up circuit 11 performs the on and off control on a built-in transistor connected to the switching terminal SW to step up the voltage input to the switching terminal SW via the reactor L 11, and outputs the stepped-up voltage from the output terminal VOUT. A heating voltage V_{HEAT} output from the output terminal VOUT of the step-up circuit 11 is, for example, a voltage of 4 V The input terminal VIN of the step-up circuit 11 constitutes a power supply terminal on a high potential side of the step-up circuit 11. The step-up circuit 11 outputs the heating voltage V_{HEAT} when a signal input from an output terminal Y of the AND gate 10 described later to the enable terminal EN is at a high level, and stops outputting the heating voltage V_{HEAT} when the signal input to the enable terminal EN is at a low level.

The output terminal VOUT of the step-up circuit 11 is connected in parallel with the capacitor C1, a voltage divider circuit including a series circuit of the resistor R7 and the resistor R6, the multiplexer 8, the switch Q1, the switch Q2, and the switch Q5. Specifically, the output terminal VOUT of the step-up circuit 11 is connected to the other end of the capacitor C1 whose one end is connected to the ground line, an input terminal (a terminal of the resistor R7 on a side opposite to a resistor R6 side) of the voltage divider circuit including the resistor R6 connected to the ground line and the resistor R7 connected in series with the resistor R6, a terminal VCC of the multiplexer 8, the source terminal of the switch Q1, the source terminal of the switch Q2, and the source terminal of the switch Q5.

The resistor RA having an electrical resistance value Ra is connected in parallel to the switch Q1. The resistor RB having an electrical resistance value Rb is connected in parallel to the switch Q2.

The multiplexer 8 has an input terminal B0, an input terminal B 1, an output terminal A, and a select terminal SE. The multiplexer 8 switches between a state where the input terminal B0 and the output terminal A are connected and a state where the input terminal B 1 and the output terminal A are connected, according to a control signal input from a terminal P15 of the MCU 6 to the select terminal SE.

The input terminal B0 of the multiplexer 8 is connected to a line connecting the switch Q1 and the terminal HT1 (P1). The input terminal B1 of the multiplexer 8 is connected to a line connecting the switch Q2 and the terminal HT1 (P2). The output terminal A of the multiplexer 8 is connected to a non-inverting input terminal of the operational amplifier OP1. An inverting input terminal of the operational amplifier OP1 is connected to a node connecting the resistor R7 and the resistor R6. An output terminal of the operational amplifier OP1 is connected to a terminal P14 of the MCU 6.

In a state where a signal input to the control terminal CTL is at a high level (in other words, a state where the system power supply voltage V_{SYS} is output from the output terminal SYS of the charging IC 3), the LDO 4 converts the voltage input to the input terminal VIN (that is, the system power supply voltage V_{SYS}) and outputs the obtained voltage from the output terminal OUT as a system power supply voltage V_{MCU}. The system power supply voltage V_{SYS} is, for example, a value in a range of 3.5 V to 4.2 V, and the system power supply voltage V_{MCU} is, for example, 3.1 V

The control IC of the OLED panel 17, the MCU 6, the LSW 7, the inhalation sensor 15, a series circuit including the resistor R3, the resistor R4, and the switch BT, and the debugging connector 20E are connected in parallel to the output terminal OUT of the LDO 4. Specifically, the output terminal OUT of the LDO 4 is connected to the terminal VDD of the OLED connector 20C, a power supply terminal VDD of the MCU 6, an input terminal VIN of the LSW 7, the other end (a node N1 in the drawing) of the resistor R5 whose one end is connected to the terminal VMCU of main connector 20A, the input terminal (the node N1 in the drawing) of the voltage divider circuit including the resistor R4 and the resistor R3, and the terminal VMCU of the debugging connector 20E.

The output terminal OUT of the LDO 4 is connected to a source terminal of the switch Q6 whose gate terminal is connected to a terminal P4 of the MCU 6. A terminal VCC of the AND gate 10, a terminal VCC of the FF 9, one end of the resistor R11, one end of the resistor R12, a positive power supply terminal of the operational amplifier OP2, one end of the resistor R8, one end of the resistor R9, and a positive power supply terminal of the operational amplifier OP1 are connected in parallel to a drain terminal of the switch Q6.

The other end of the resistor R12 is connected to the second thermistor terminal TH2, a series circuit of the resistor R12 and the second thermistor th2 connected to the second thermistor terminal TH2 constitutes a voltage divider circuit to which the system power supply voltage V_{MCU} is applied. An output of this voltage divider circuit corresponds to an electrical resistance value (in other words, a temperature) of the second thermistor th2 and is input to a terminal P8 of the MCU 6. Accordingly, the MCU 6 can acquire the temperature of the second thermistor th2. In the present embodiment, as the second thermistor th2, a thermistor having an NTC characteristic in which a resistance value decreases as a temperature increases is used, and a thermistor having a PTC characteristic in which the resistance value increases as a temperature increases.

The other end of the resistor R9 is connected to one end of the resistor R10, and the other end of the resistor R10 is connected to the ground line. A series circuit of the resistor R9 and the resistor R10 constitutes a voltage divider circuit to which the system power supply voltage V_{MCU} is applied. An output of the voltage divider circuit is connected to an inverting input terminal of the operational amplifier OP2, and a fixed voltage value is input to this inverting input terminal. A non-inverting input terminal of the operational amplifier OP2 is connected to the other end of the resistor R8.

The other end of resistor R8 is further connected to the first thermistor terminal TH1 and a terminal P9 of the MCU 6. A series circuit of the resistor R8 and the first thermistor th1 connected to the first thermistor terminal TH1 constitutes a voltage divider circuit to which the system power supply voltage V_{MCU} is applied. An output of this voltage divider circuit corresponds to an electrical resistance value (in other words, a temperature) of the first thermistor th1 and is input to the terminal P9 of the MCU 6. Accordingly, the MCU 6 can acquire the temperature of the first thermistor th1 (in other words, a temperature of the seat heater HTR). An output of this voltage divider circuit is also input to the non-inverting input terminal of the operational amplifier OP2. In the present embodiment, as the first thermistor th1, a thermistor having a NTC characteristic in which a resistance value decreases as a temperature increases is used. Therefore, an output of the operational amplifier OP2 is at a low level when the temperature of the first thermistor th1 (the temperature of the seat heater HTR) increases and becomes equal to or higher than a threshold THD1. In other words, as long as the temperature of the first thermistor th1 (the temperature of the seat heater HTR) is within a normal range, the output of the operational amplifier OP2 is at a high level.

As the first thermistor th1, when using a thermistor having a PTC characteristic in which a resistance value increases as a temperature increases, an output of the voltage divider circuit including the first thermistor th1 and the resistor R8 may be connected to the inverting input terminal of the operational amplifier OP2, and an output of the voltage divider circuit including the resistor R9 and the resistor R10 may be connected to the non-inverting input terminal of the operational amplifier OP2. In this case, the output of the operational amplifier OP2 also is at a low level when the temperature of the first thermistor th1 (the temperature of the seat heater HTR) increases and becomes equal to or higher than the threshold THD1.

An output terminal of the operational amplifier OP2 is connected to an input terminal D of the FF 9. A node connecting the input terminal D of the FF 9 and the output terminal of the operational amplifier OP2 is connected to the other end of the resistor R11 and a negative logic clear terminal CLR (⁻) provided to the FF 9. That is, the input terminal D of the FF 9, the clear terminal CLR (⁻) of the FF 9, and the output terminal of the operational amplifier OP2 are respectively pulled up to a supply line of the system power supply voltage V_{MCU} by the resistor R11.

The FF 9 includes a clock terminal CLK, and the clock terminal CLK is connected to a terminal P7 of the MCU 6. The FF 9 has an output terminal Q, and the output terminal Q is connected to an input terminal B of the AND gate 10. In a state where a clock signal is input from the MCU 6 to the clock terminal CLK and a high-level signal is input to the clear terminal CLR (⁻), the FF 9 holds data (high or low data) according to levels of the signals input to the input terminal D, and outputs the held data from the output terminal Q. In a state where the clock signal is input from the MCU 6 to the clock terminal CLK and a low-level signal is input to the clear terminal CLR (⁻), the FF 9 performs reset processing to output the low-level signal from the output terminal Q regardless of the held data. The reset processing is canceled by re-inputting the clock signal to the clock terminal CLK in a state where a high-level signal is input to the clear terminal CLR (⁻). That is, in the state where a high-level signal is input to the clear terminal CLR (⁻), the reset processing is canceled by stopping supply of the clock signal to the clock terminal CLK and then restarting the supply of the clock signal.

An input terminal A, which is the other input terminal, of the AND gate 10 is connected to a terminal P6 of the MCU 6. The output terminal Y of the AND gate 10 is connected to the positive logic enable terminal EN of the step-up circuit 11. The AND gate 10 outputs a high-level signal from the output terminal Y only when a signal input to the input terminal A and a signal input to the input terminal B are both at a high level.

When a control signal is input to the control terminal CTL from a terminal P10 of the MCU 6, the LSW 7 outputs the system power supply voltage V_{MCU} input to the input terminal VIN from the output terminal OUT. The output terminal OUT of the LSW 7 is connected to the vibration motor 13 via the terminal VIB of the main board 20 and the terminal VIB of the puff sensor board 21. Therefore, by inputting a control signal to the LSW 7 from the MCU 6, the vibration motor 13 can operate by using the system power supply voltage V_{MCU}.

### (Transition from Standby Mode to Heating Mode)

The power supply unit 100 includes, as operation modes, a sleep mode for power saving, a standby mode that can be transitioned from the sleep mode, and a heating mode (a mode in which the liquid heater and the seat heater HTR are heated to generate an aerosol) that can be transitioned from the standby mode. When the MCU 6 detects a specific operation (for example, a long press operation) on the switch BT in the sleep mode, the MCU 6 switches the operation mode to the standby mode. When the MCU 6 detects a specific operation (for example, a short press operation) on the switch BT in the standby mode, the MCU 6 switches the operation mode to the heating mode.

### (Operation of Heating Mode)

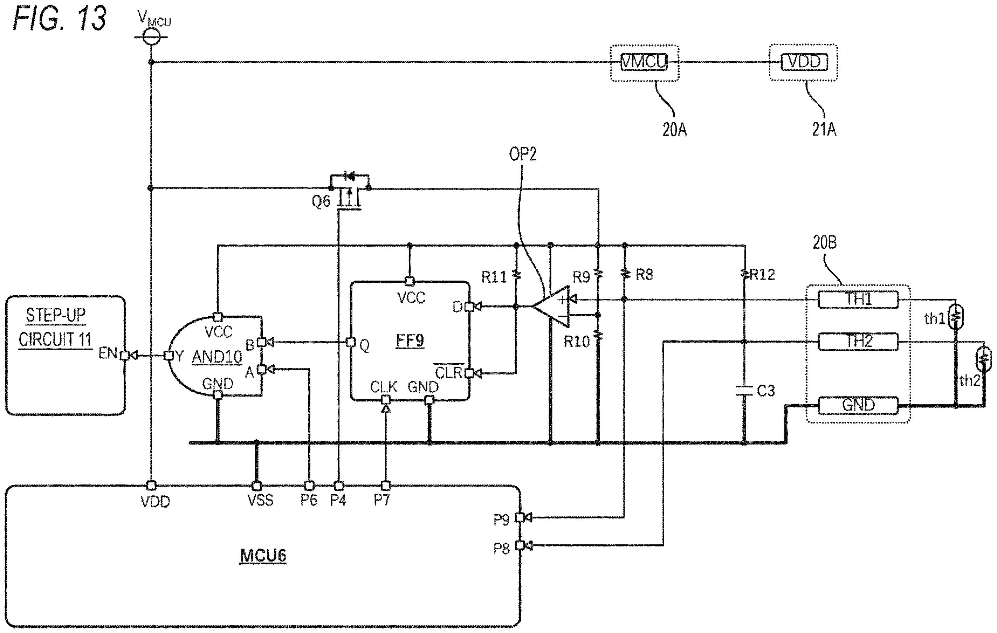

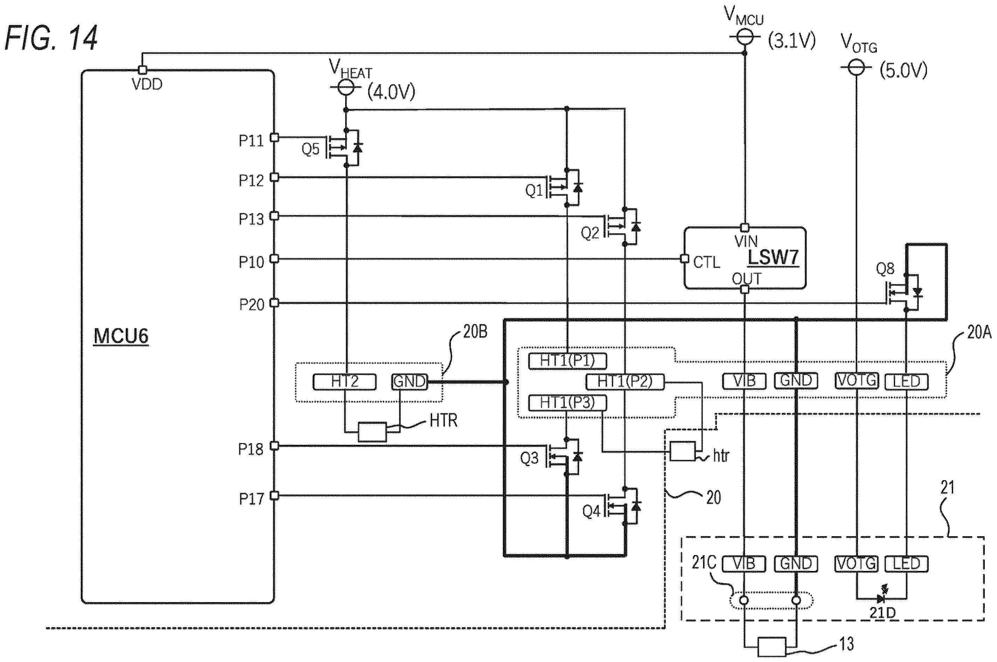

Fig. 13 is a circuit diagram in which electronic components related to an operation of the heating mode are extracted from the circuit shown in Fig. 12. Fig. 13 additionally shows a capacitor C3 which is not shown in Fig. 12. Fig. 14 is a circuit diagram in which electronic components related to the heating control on the seat heater HTR and the liquid heater, drive control on the vibration motor 13, and drive control on the LED 21D are extracted from the circuit shown in Fig. 12. The operation of the heating mode will be described below with reference to Figs. 13 and 14.

When transitioning to the heating mode, the MCU 6 controls the switch Q6 shown in Fig. 13 to the ON state. Accordingly, the system power supply voltage V_{MCU} is supplied to the AND gate 10, the FF 9, the resistor R11, the operational amplifier OP2, the resistor R11, the voltage divider circuit including the resistor R9 and the resistor R10, the voltage divider circuit including the resistor R8 and the first thermistor th1, the voltage divider circuit including the resistor R12 and the second thermistor th2, and the operational amplifier OP1. Furthermore, when transitioning to the heating mode, the MCU 6 controls a signal input from the terminal P6 to the input terminal A of the AND gate 10 to a high level. The MCU 6 also starts inputting the clock signal to the clock terminal CLK of the FF 9. In this state, if the temperature of the first thermistor th1 (the temperature of the seat heater HTR) is within the normal range (less than the threshold THD1), the output of the operational amplifier OP2 is at a high level, and as a result, the output of the FF 9 is at a high level, and as a result, the output of the AND gate 10 is at a high level. Therefore, the heating voltage V_{HEAT} is started to be output from the step-up circuit 11, and the seat heater HTR and the liquid heater can be heated.

### (Determination of Connection Destination of Liquid Heater)

When the heating voltage V_{HEAT} is started to be output from the step-up circuit 11, as shown in Fig. 14, power can be supplied to the seat heater HTR connected to the seat heater terminal HT2 and the liquid heater connected to any two of the terminal HT1 (P1) to the terminal HT1 (P3) (in Fig. 14, a liquid heater htr connected to the terminal HT1 (P1) and the terminal HT1 (P2) is illustrated). In this state, the MCU 6 first determines to which two of the pogo pin p1, pogo pin p2, and the pogo pin p3 the liquid heater is connected by the output of the operational amplifier OP1 shown in Fig. 12. This determination step includes the following first step, second step, and third step.

### (First Step)

The MCU 6 performs control to connect the input terminal B0 and the output terminal A of the multiplexer 8 while controlling only the switch Q4 of the switches Q1 to Q4 to be turned on. In this state, if Rx represents an electrical resistance value between the terminal HT1 (P1) and the terminal HT1 (P2), a divided voltage value = V_{HEAT} * {Rx/(Ra + Rx)} is input to the non-inverting input terminal of the operational amplifier OP1. In the operational amplifier OP1, a voltage input to the non-inverting input terminal is compared with the divided voltage value when the liquid heater is connected between the terminal HT1 (P1) and the terminal HT1 (P2), and if a difference therebetween is small, the output of the operational amplifier OP1 is at a low level. Therefore, if the output of the operational amplifier OP1 is at a low level, the MCU 6 determines that the liquid heater is connected between the terminal HT1 (P1) and the terminal HT1 (P2).

### (Second Step)

If the output of the operational amplifier OP1 is at a high level in the first step, the MCU 6 performs control to connect the input terminal B0 and the output terminal A of the multiplexer 8 while controlling only the switch Q3 of the switches Q1 to Q4 to be turned on. In this state, if the liquid heater is connected between the terminal HT1 (P1) and the terminal HT1 (P3), the output of the operational amplifier OP1 is at a low level. Therefore, if the output of the operational amplifier OP1 is at a low level, the MCU 6 determines that the liquid heater is connected between the terminal HT1 (P1) and the terminal HT1 (P3).

### (Third Step)

If the output of the operational amplifier OP1 is at a high level in the second step, the MCU 6 performs control to connect the input terminal B 1 and the output terminal A of the multiplexer 8 while controlling only the switch Q3 of the switches Q1 to Q4 to be turned on. In this state, if the liquid heater is connected between the terminal HT1 (P2) and the terminal HT1 (P3), the output of the operational amplifier OP1 is at a low level. Therefore, if the output of the operational amplifier OP1 is at a low level, the MCU 6 determines that the liquid heater is connected between the terminal HT1 (P2) and the terminal HT1 (P3).

The MCU 6 issues an error notification when the output of the operational amplifier OP1 is not at a low level in any of the first step to the third step.

### (Start of Heating Control)

In a state where the above determination step is ended, when an output level of the inhalation sensor 15 changes to a value corresponding to that in a case where the user performs inhalation, the MCU 6 starts the heating control on the seat heater HTR and the liquid heater. Specifically, the MCU 6 performs the heating control on the seat heater HTR by controlling on and off of (for example, performing PWM control or PFM control on) the switch Q5 shown in Fig. 14. In this case, the MCU 6 performs the heating control on the seat heater HTR such that the temperature of the seat heater HTR converges to a target temperature based on the temperature of the second thermistor th2 (in other words, the temperature of the seat heater HTR) acquired from the signal input to the terminal P8. For example, proportional-integral-differential (PID) control is used for the heating control.

When the liquid heater is connected between the terminal HT1 (P1) and the terminal HT1 (P2), among the switches Q1 to Q4 shown in Fig. 14, the MCU 6 controls the switch Q4 to be in the ON state, controls the switch Q2 and the switch Q3 to be in the OFF state, and controls on and off of (for example, performs the PWM control or the PFM control on) the switch Q1 to perform the heating control on the liquid heater. When the liquid heater is connected between the terminal HT1 (P1) and the terminal HT1 (P3), among the switches Q1 to Q4, the MCU 6 controls the switch Q3 to be in the ON state, controls the switch Q2 and the switch Q4 to be in the OFF state, and controls on and off of the switch Q1 to perform the heating control on the liquid heater. When the liquid heater is connected between the terminal HT1 (P2) and the terminal HT1 (P3), among the switches Q1 to Q4, the MCU 6 controls the switch Q3 to be in the ON state, controls the switch Q1 and the switch Q4 to be in the OFF state, and controls on and off of the switch Q2 to perform the heating control on the liquid heater.

As shown in Fig. 13, the system power supply voltage V_{MCU} output from the LDO 4 is constantly supplied to the inhalation sensor 15 connected to the puff sensor connector 21A. On the other hand, the system power supply voltage V_{MCU} is supplied via the switch Q6 to the electronic components necessary to operate only in the heating mode. According to such a configuration, power consumption of the electronic component can be reduced except in the heating mode. Immediately after the system power supply voltage V_{MCU} is applied to the inhalation sensor 15, an operation of the inhalation sensor 15 may become unstable. Therefore, the system power supply voltage V_{MCU} is constantly supplied to the inhalation sensor 15, so that the inhalation operation can be detected by the inhalation sensor 15 with high accuracy even when the inhalation is performed immediately after the mode transitions to the heating mode.

In the present embodiment, the puff sensor board 21 on which the inhalation sensor 15 is mounted and the main board 20 on which the MCU 6 likely to be a noise source is mounted are physically separated. Accordingly, the inhalation sensor 15, which constantly operates, can be operated more stably. The switch BT likely to be an entry port for noise of static electricity and the like is not mounted on the puff sensor board 21, and the switch BT is directly mounted on the main FPC 23. Accordingly, the inhalation sensor 15, which constantly operates, can also be operated more stably. The switch BT is mounted on the flexible main FPC 23, so that a distance between the switch BT and the inhalation sensor 15 can be easily increased.

Fig. 14 shows connectors (the main connector 20A and the heater connector 20B) electrically connected to the power supply ba, the LED 21D and the vibration motor 13 connected to the main connector 20A via cables such as the FPCs and the lead wire, the switch Q8 electrically connected to a low potential side of the main connector 20A and capable of opening and closing electrical connection between the power supply ba and the LED 21D, and the LSW 7 electrically connected to a high potential side of the main connector 20A and capable of opening and closing electrical connection between the power supply ba and the vibration motor 13.

Here, attention is focused on the LED 21D and the vibration motor 13 which are loads receiving the supply of power from the power supply ba. Vibration of the vibration motor 13 can generate a counter electromotive force (reverse current flowing from a low potential side to a high potential side). In the present embodiment, the switch used for controlling the power supply to the vibration motor 13 is not a simple switch but the highly functional LSW 7 having a reverse prevention function. Accordingly, it is possible to prevent the counter electromotive force and reverse current generated by the vibration motor 13 from being input to the MCU 6, thereby improving durability of the MCU 6.

On the other hand, the LED 21D is driven by an operation voltage (specifically, the OTG voltage V_{OTG}) larger than an operation voltage (specifically, the system power supply voltage V_{MCU}) of the vibration motor 13, although there is no concern about the counter electromotive force. This is because it is necessary to increase the operation voltage in order to increase luminance of the LED 21D. In the present embodiment, the switch Q8 for controlling the power supply to the LED 21D is connected to the low potential side of the main connector 20A. Accordingly, even if the switch Q8 is short-circuited, it is possible to prevent the OTG voltage V_{OTG} higher than the system power supply voltage V_{MCU} from being input from the switch Q8 to the MCU 6. In this way, by providing the switch Q8 on the low potential side, the OTG voltage V_{OTG} can be set to a high value without being restricted by the system power supply voltage V_{MCU}, and the luminance of the LED 21D can be effectively increased.

Fig. 14 further shows the seat heater HTR connected to the heater connector 20B via cables such as the FPCs, the liquid heater (the liquid heater htr is shown as an example in the drawing) connected to the main connector 20A via the cables such as the FPCs, the switch Q5 electrically connected to a high potential side of the heater connector 20B and capable of opening and closing electrical connection between the power supply ba and the seat heater HTR, the switch Q1 and the switch Q2 electrically connected to the high potential side of the main connector 20A and capable of opening and closing electrical connection between the power supply ba and the liquid heater, and the switch Q3 and the switch Q4 electrically connected to the low potential side of the main connector 20A and capable of opening and closing the electrical connection between the power supply ba and the liquid heater.

Here, attention is focused on the seat heater HTR and the liquid heater which are loads receiving the supply of power from the power supply ba. Since the liquid heater needs to atomize the aerosol source, it is necessary to supply a lot of power per unit time. On the other hand, the seat heater HTR only needs to be supplied with enough power to increase an amount of flavors released from the flavor source, and thus, the power required to be supplied per unit time is less than that of the liquid heater. Therefore, the switches Q1 to Q4 for controlling the power supply to the liquid heater are more likely to be short-circuited than the switch Q5 for controlling the power supply to the seat heater HTR.

In the present embodiment, the switch Q1 and the switch Q2 are connected to a high potential side of the liquid heater (in other words, between the power supply ba and the liquid heater), and the switch Q3 and the switch Q4 are connected to a low potential side of the liquid heater (in other words, between the ground and the liquid heater). Accordingly, even if any one of the switch Q1 or switch Q2 connected to the liquid heater and the switch Q3 or switch Q4 connected to the liquid heater is short-circuited, the other switch is controlled to be in the OFF state, so that it is possible to prevent a short-circuit current of the one switch from continuing to be supplied to the liquid heater. Accordingly, safety of the power supply unit 100 can be improved. The electrical resistance value Ra of the resistor RA connected in parallel to the switch Q1 and the electrical resistance value Rb of the resistor RB connected in parallel to the switch Q2 are sufficiently high values. It should be noted that the short-circuit currents through the resistor RA and the resistor RB are never supplied to the liquid heater.

In the present embodiment, only the switch Q5 is connected to a high potential side of the seat heater HTR (in other words, between the seat heater HTR and the power supply ba). As described above, since a possibility of the short-circuiting of the switch Q5 is low, the safety can be ensured without providing another switch between the seat heater HTR and the ground. The seat heater HTR is controlled by a protection circuit described later such that the temperature of the seat heater HTR does not become excessively high. Therefore, even if the switch Q5 is short-circuited, a function of the protection circuit can prevent the seat heater HTR from being continuously heated. From this point of view as well, the safety can be ensured without providing another switch between the seat heater HTR and the ground. By using only one switch to connect to the seat heater HTR in this way, the number of components of the power supply unit 100 can be reduced, and a manufacturing cost of the power supply unit 100 can be reduced.

### (Overheating Protection of Heater)

In the power supply unit 100, the electrical resistance values of the resistor R8, the resistor R9, and the resistor R10 are determined such that if the temperature of the first thermistor th1 becomes equal to or higher than the threshold THD1 in the heating mode, the output of the operational amplifier OP2 is at a low level. If the temperature of the first thermistor th1 becomes equal to or higher than the threshold THD 1 and the output of the operational amplifier OP2 is at a low level, the low level is input to the clear terminal CLR (⁻) of the FF 9. Accordingly, the data held by the FF 9 is canceled and the output of the FF 9 is forced to be at a low level, and thus, the output of the AND gate 10 is also at a low level, and the step-up circuit 11 stops outputting the heating voltage V_{HEAT}. That is, a matter that the output of the operational amplifier OP2 is at a low level means that a signal input to the enable terminal EN of the step-up circuit 11 is at a low level.

If the control on the supply of power from the MCU 6 to the seat heater HTR functions normally, the temperature of the first thermistor th1 does not become equal to or higher than the threshold THD 1 in principle. That is, if the temperature of the first thermistor th1 becomes equal to or higher than the threshold THD 1, there is a high possibility that the MCU 6 or the circuit (specifically, the switch Q5) that supplies power to the seat heater HTR has some problem.

In the present embodiment, the low-level signal output from the operational amplifier OP2 does not control the MCU 6 or the switch Q5, but controls the step-up circuit 11 that outputs the heating voltage V_{HEAT} to cause the heating of the seat heater HTR to stop. In this way, the output signal of the operational amplifier OP2 is input to the step-up circuit 11 that can reliably stop the supply of power to the seat heater HTR, so that safety in a case where the temperature of the seat heater HTR becomes high is improved. For example, if the temperature of the first thermistor th1 becomes equal to or higher than the threshold THD1 due to the MCU 6 being frozen or the switch Q5 being short-circuited, the MCU 6 or the switch Q5 cannot be controlled. Also in such a case, the low-level signal from the operational amplifier OP2 is input to the enable terminal EN of the step-up circuit 11, so that the supply of power to the seat heater HTR can be reliably stopped.

As a method of stopping the output of the heating voltage V_{HEAT} from the step-up circuit 11, a method of inputting a high-level signal to the enable terminal CE (⁻) of the charging IC that generates the system power supply voltage V_{SYS} input to the step-up circuit 11 is also conceivable. With respect to this method, according to the configuration in which the output of the operational amplifier OP2 can be input to the enable terminal EN of the step-up circuit 11, an advantage of simplifying a circuit configuration and reducing the manufacturing cost is present.

In order to return the output of the FF 9 to a high level, it is necessary to re-input the clock signal to the clock terminal CLK of the FF 9 by the MCU 6 (in other words, restart the FF 9). That is, even if the temperature of the first thermistor th1 returns to a temperature less than the threshold THD 1 after the output from the step-up circuit 11 is stopped, the output from the step-up circuit 11 is not restarted unless the MCU 6 restarts the FF 9.

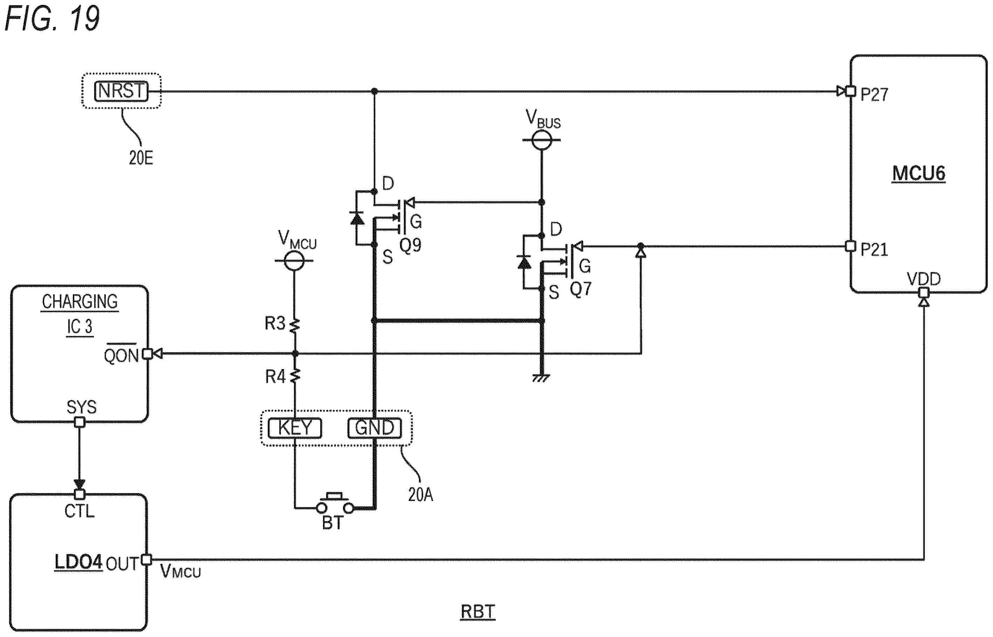

It is assumed that a reason why the temperature of the first thermistor th1 becomes equal to or higher than the threshold THD1 is that the MCU 6 is frozen. In this case, a high-level signal continues to be input to the input terminal A of the AND gate 10, and a clock signal continues to be input to the FF 9. The aerosol generating device 200 is provided with a restart circuit RBT (see Fig. 19) capable of restarting (resetting) the MCU 6 by an operation of the user on the switch BT, which will be described later in detail. If a reason for the functioning of the protection circuit is the freezing of the MCU 6, the MCU 6 is restarted by the user. By restarting the MCU 6, the FF 9 is restarted. By restarting the MCU 6, a signal input to the input terminal A of the AND gate 10 is at a low level. At a timing when the MCU 6 is restarted, the switch Q6 is in the OFF state, and thus, potential of a signal at the input terminal B of the AND gate 10 is undefined. Therefore, the output from the step-up circuit 11 is not restarted by merely restarting the MCU 6. After the MCU 6 is restarted, the operation mode shifts to the heating mode by an operation of the user, so that a signal input to the input terminal A of the AND gate 10 is at a high level. The switch Q6 is in the ON state, so that a signal input to the input terminal B of the AND gate 10 is at a high level. Accordingly, the output from the step-up circuit 11 is restarted.

In this way, the MCU 6 controls the restart of the output from the step-up circuit 11 (control is performed to reflect an intention of the user and then restart the output), so that it is possible to prevent that the heating of the seat heater HTR is restarted contrary to the intention of the user, thereby improving safety and convenience.

As described above, the AND gate 10, the FF 9, and the operational amplifier OP2 constitute the protection circuit for protecting the seat heater HTR by stopping the supply of power to the seat heater HTR when the temperature of the seat heater HTR becomes high. This protection circuit does not receive a command from the MCU 6 to disable the step-up circuit 11, in other words, can autonomously stop the output from the step-up circuit 11 according to the temperature of the first thermistor th1 even in a state where a high-level signal is input to the input terminal A of the AND gate 10 and a clock signal is input to the clock terminal CLK of the FF 9. Accordingly, even if the MCU 6 has a problem such as freezing, since the heating performed by the seat heater HTR and the liquid heater can be urgently stopped, the safety of the aerosol generating device 200 can be improved.

If the MCU 6 determines that the temperature of the second thermistor th2 acquired based on the signal input to the terminal P8 is equal to or higher than a threshold THD2 (this value is smaller than the threshold THD1), the MCU 6 makes the signal input to the input terminal A of the AND gate 10 at a low level. Accordingly, the output of the AND gate 10 is at a low level, and the step-up circuit 11 stops outputting the heating voltage V_{HEAT}. As described above, when the MCU 6 operates normally, the output from the step-up circuit 11 can be stopped by a command from the MCU 6 as well. Accordingly, for example, even if the first thermistor th1 does not operate normally, the output from the step-up circuit 11 can be stopped by a command from the MCU 6 to improve the safety. The threshold THD2 is smaller than the threshold THD1. Therefore, if the MCU 6 operates normally, when the temperature of the seat heater HTR becomes high, the MCU 6, prior to the protection circuit, can stop the output from the step-up circuit 11, so that the safety can be further improved.

In the present embodiment, the MCU 6 can acquire the temperature of the first thermistor th1 from a signal input to the terminal P9. Therefore, the MCU 6 determines whether the temperature of the second thermistor th2 can be acquired normally, if the temperature of the second thermistor th2 cannot be acquired normally, the MCU 6 preferably performs the heating control on the seat heater HTR based on the temperature of the first thermistor th1 such that the temperature of the seat heater HTR converges to a target temperature. Accordingly, even when the second thermistor th2 has some kind of abnormality, the heating control on the seat heater HTR can be executed by the first thermistor th1. Whether the temperature of the second thermistor th2 can be normally acquired can be determined by determining whether the signal input to the terminal P8 indicates an abnormal value, or by determining whether the signal can be acquired.

Basically, here, the MCU 6 executes the heating control on the seat heater HTR based on the temperature of the second thermistor th2. Therefore, it is preferable to dispose the second thermistor th2 at a position that can more accurately reflect the temperature of the seat heater HTR. On the other hand, the first thermistor th1 is mainly used to stop the output from the step-up circuit 11 by the protection circuit when the temperature of the seat heater HTR becomes high. Therefore, it is preferable to dispose the first thermistor th1 at a position where the temperature of the seat heater HTR is likely to become higher such that a high-temperature state of the seat heater HTR can be reliably detected. A detailed configuration of the heater FPC 24 on which the first thermistor th1 and the second thermistor th2 are mounted will be described later.

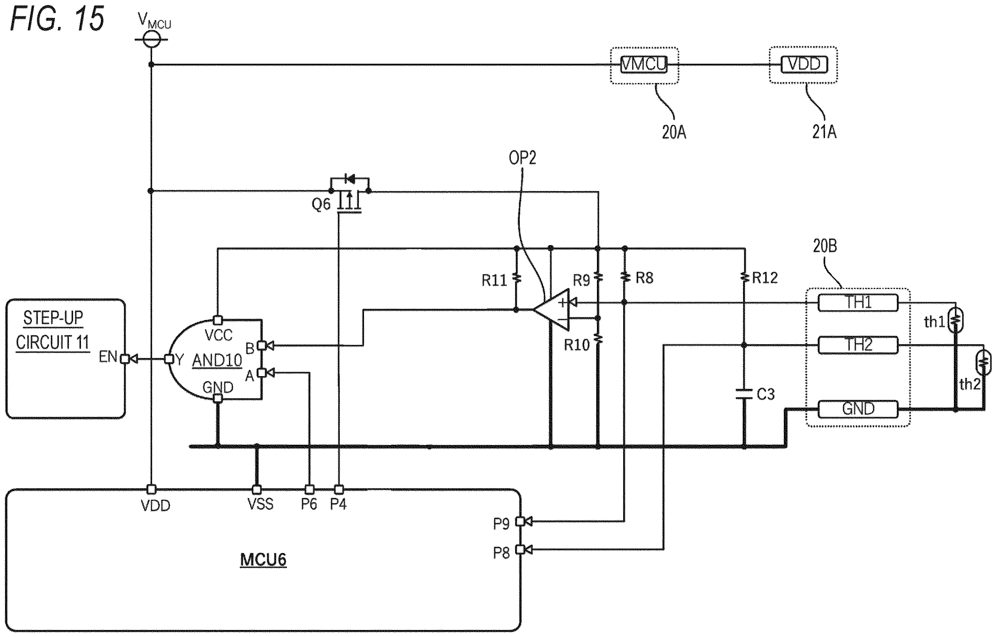

In the protection circuit described above, the FF 9 is not essential and can be omitted. Fig. 15 is a circuit diagram corresponding to Fig. 13 when the FF 9 is omitted. When the FF 9 is omitted, the output terminal of the operational amplifier OP2 may be connected to the input terminal B of the AND gate 10 as shown in Fig. 15. In a configuration shown in Fig. 15, if the temperature of the first thermistor th1 becomes equal to or higher than the threshold THD1 and the output of the operational amplifier OP2 is at a low level, the output of the AND gate 10 is at a low level. Accordingly, when the temperature of the seat heater HTR becomes high, the output from the step-up circuit 11 can be stopped. According to the configuration shown in Fig. 15, since the FF 9 can be eliminated, the power supply unit 100 can be miniaturized, a weight thereof can be reduced, and power saving thereof can be achieved.

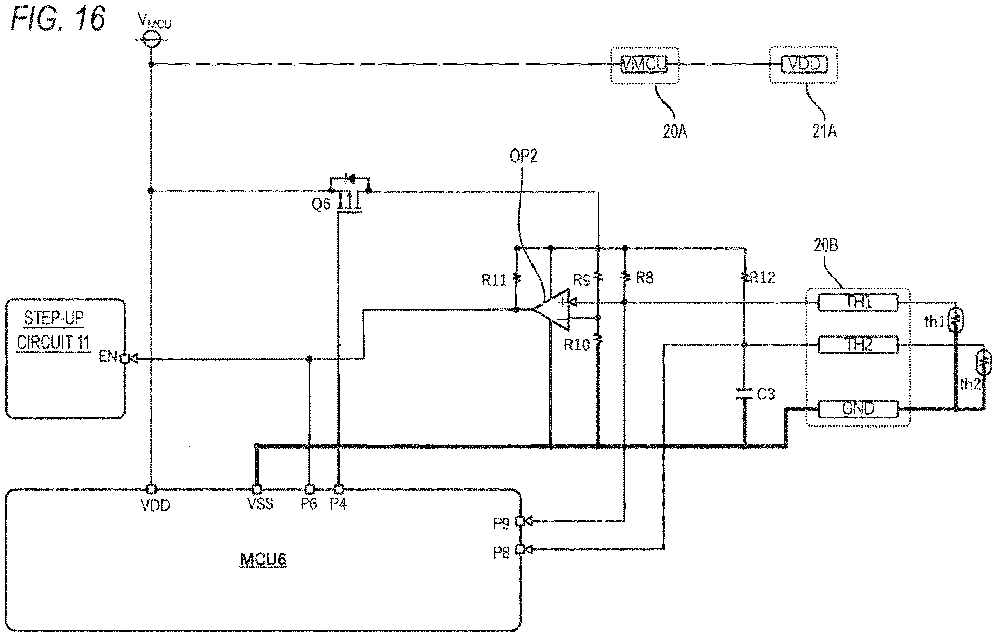

In the protection circuit described above, both the FF 9 and the AND gate 10 can be omitted. Fig. 16 is a circuit diagram corresponding to Fig. 13 when the FF 9 and the AND gate 10 are omitted. When the FF 9 and the AND gate 10 are omitted, as shown in Fig. 16, the output terminal of the operational amplifier OP2 and the terminal P6 of the MCU 6 may be connected to the enable terminal EN of the step-up circuit 11. In a configuration shown in Fig. 16, if the temperature of the first thermistor th1 becomes equal to or higher than the threshold THD1 and the output of the operational amplifier OP2 is at a low level, even when a high-level signal is output from the terminal P6 of the MCU 6, the enable terminal EN of the step-up circuit 11 is at a low level. Accordingly, when the temperature of the seat heater HTR becomes high, the output from the step-up circuit 11 can be stopped. According to the configuration shown in Fig. 16, since the FF 9 and the AND gate 10 can be eliminated, the power supply unit 100 can be miniaturized, the weight thereof can be reduced, and power saving thereof can be achieved.

### (Configuration of Heater FPC 24)

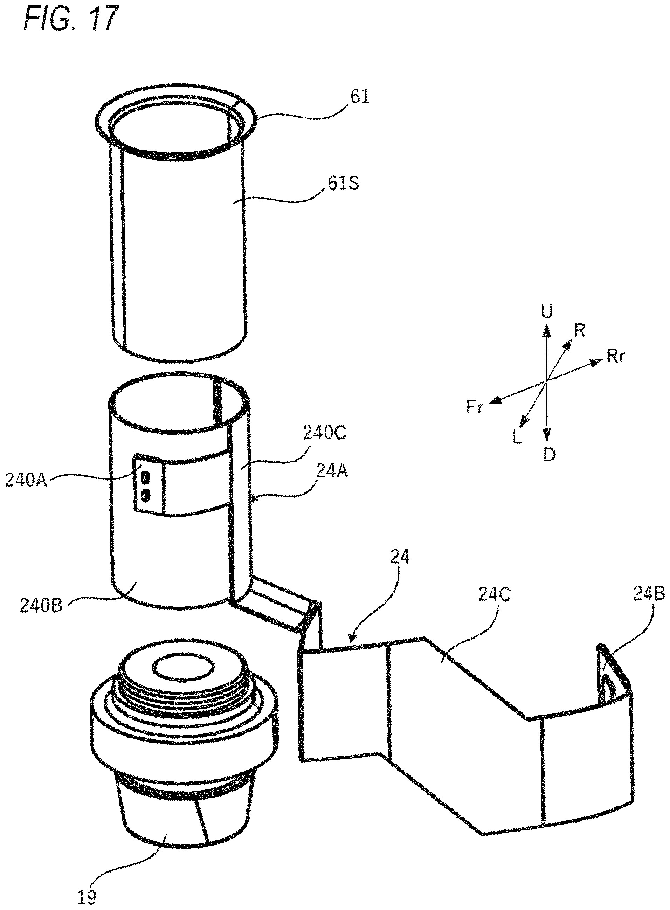

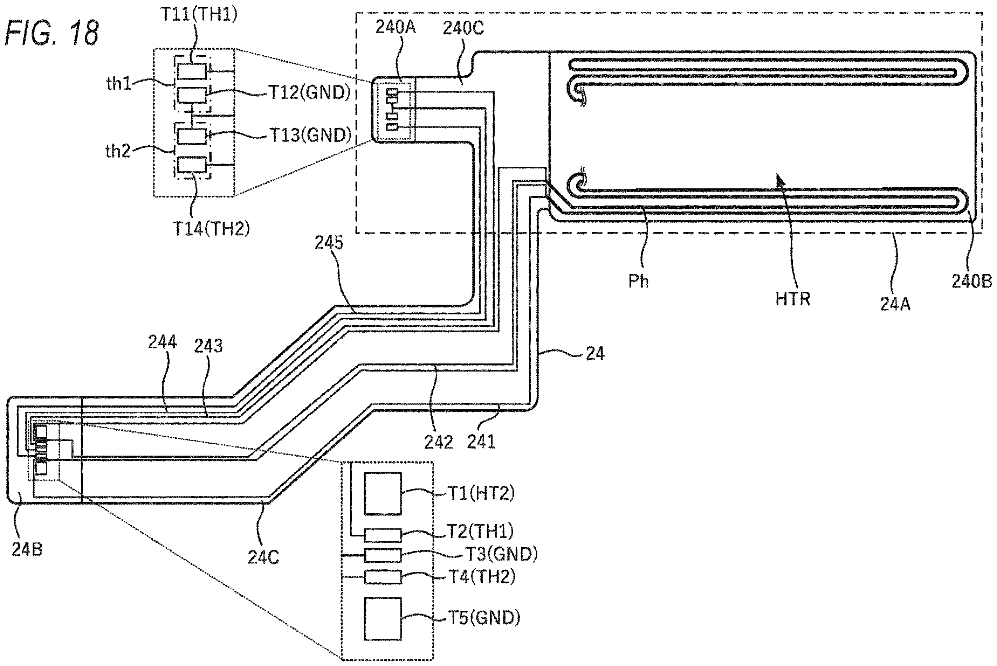

Fig. 17 is an exploded perspective view of the heating portion 60 and the flow path forming body 19 shown in Fig. 6. Fig. 18 is a developed view of the heater FPC 24 shown in Fig. 17. The heat transfer tube 61 and the flow path forming body 19 are fixed in a state where an upper end portion of the flow path forming body 19 is inserted through a lower end portion of the heat transfer tube 61. Accordingly, the flow path forming body 19 functions as a pedestal against which a bottom of the second cartridge 120 abuts with the second cartridge 120 housed inside the heat transfer tube 61. The flow path forming body 19 is preferably made of a material having a high heat-insulating function, such as silicone. When the flow path forming body 19 is made of a material having a high heat-insulation function, the heat of the seat heater HTR is transmitted not only to the second cartridge 120 but also to the flow path forming body 19 on a lower end side of the heat transfer tube 61.

The heater FPC 24 includes a winding region 24A wound around and fixed to an outer peripheral surface 61S of the heat transfer tube 61 implemented by a cylindrical body, a connector region 24B inserted into the heater connector 20B of the main board 20, and a connecting region 24C connecting the winding region 24A and the connector region 24B.

The winding region 24A includes a thermistor mounting region 240A in which the first thermistor th1 and the second thermistor th2 are mounted, a heater region 240B in which a conductive pattern Ph constituting the seat heater HTR is formed, and an intermediate region 240C between the thermistor mounting region 240A and the heater region 240B. In this way, the seat heater HTR, the first thermistor th1, and the second thermistor th2 are mounted on the same FPC, so that compared with a case where the seat heater HTR and the thermistors are provided on separate boards, the configuration can be simplified, and a cost and size of the power supply unit 100 can be reduced.

As shown in Fig. 17, the winding region 24A is wound around the outer peripheral surface 61S of the heat transfer tube 61 in a state where the thermistor mounting region 240A overlaps the heater region 240B on a side opposite to the heat transfer tube 61 when viewed in a radial direction of the heat transfer tube 61. According to this configuration, the seat heater HTR, the first thermistor th1, and the second thermistor th2 can be disposed as close as possible, and thus, precision of the heating control on the seat heater HTR and the protection control performed by the protection circuit can be improved.

As shown in Fig. 18, in the thermistor mounting region 240A, a terminal T11, a terminal T12, a terminal T13, and a terminal T14 are arranged side by side in an axial direction of the heat transfer tube 61. The positive side terminal of the first thermistor th1 is connected to the terminal T11, and the negative side terminal of the first thermistor th1 is connected to the terminal T12. The negative side terminal of the second thermistor th2 is connected to the terminal T13, and the positive side terminal of the second thermistor th2 is connected to the terminal T14. As shown in the enlarged view in the upper left of Fig. 18, the first thermistor th1 and the second thermistor th2 are mounted side by side in the thermistor mounting region 240A in the axial direction of the heat transfer tube 61 with longitudinal directions of the first thermistor th1 and the second thermistor th2 aligned with the axial direction of the heat transfer tube 61.

The first thermistor th1 and the second thermistor th2 are aligned in the axial direction of the heat transfer tube 61 in this way, so that compared with a configuration in which the first thermistor th1 and the second thermistor th2 are aligned in a circumferential direction of the heat transfer tube 61, a width in the axial direction of the thermistor mounting region 240A can be increased. The longitudinal directions of the first thermistor th1 and the second thermistor th2 are aligned with the axial direction of the heat transfer tube 61, so that compared with a configuration in which the longitudinal directions of the first thermistor th1 and the second thermistor th2 are orthogonal to the axial direction of the heat transfer tube 61, the width in the axial direction of the thermistor mounting region 240A can be increased. Accordingly, durability of the heater FPC 24 can be improved.

If the longitudinal directions of the first thermistor th1 and the second thermistor th2 are not orthogonal to the axial direction of the heat transfer tube 61, an effect of increasing the width in the axial direction of the thermistor mounting region 240A can be achieved.

The second thermistor th2 is disposed closer to a center of the seat heater HTR in the axial direction (synonymous with the lateral direction of the seat heater HTR and the up-down direction of the power supply unit 100) of the heat transfer tube 61 than the first thermistor th1. That is, a shortest distance between the center of the seat heater HTR and the second thermistor th2 in the axial direction (the up-down direction in Fig. 18) of the heat transfer tube 61 is shorter than a shortest distance between the center of the seat heater HTR and the first thermistor th1 in the axial direction. According to this configuration, the second thermistor th2 disposed closer to the center in the axial direction of the seat heater HTR is less susceptible to an air cooling effect than the first thermistor t1. Therefore, an accurate temperature of the seat heater HTR can be reflected. The heating control is executed on the heater by using the second thermistor th2, so that precision of the heating control on the seat heater HTR can be improved.

The second thermistor th2 is disposed at a position closer to the flow path forming body 19 than the first thermistor th1 in the up-down direction of the power supply unit 100. That is, a shortest distance between the second thermistor th2 and the flow path forming body 19 is shorter than a shortest distance between the first thermistor th1 and the flow path forming body 19. When a high heat-insulation material such as silicone is used as the flow path forming body 19, the temperature of the second thermistor th2 closer to the flow path forming body 19 shows a value lower than the temperature of the first thermistor th1 by an amount of heat taken by the flow path forming body 19. In the present embodiment, since the heating control on the seat heater HTR is executed by using the second thermistor th2 that exhibits such a relatively low temperature, it is possible to obtain the effect that the temperature of the seat heater HTR is less likely to become high. On the other hand, the temperature of the first thermistor th1 shows a value higher than the temperature of the second thermistor th2 because of the distance from the flow path forming body 19. That is, when the seat heater HTR is excessively heated, the first thermistor th1 quickly reaches a high-temperature state reflecting the temperature thereof. Therefore, when the temperature of the seat heater HTR becomes high, the protection circuit can quickly operate, and safety can be improved.

As shown in the enlarged view at a bottom center of Fig. 18, a terminal T1, a terminal T2, a terminal T3, a terminal T4, and a terminal T5 are arranged side by side in the up-down direction in this order in the connector region 24B. In Fig. 18, the terminal names of the heater connector 20B to which the terminal T1 to the terminal T5 are connected are written in parentheses. Although one terminal GND is shown in the heater connector 20B in Fig. 12, the heater connector 20B actually includes two terminals GND as shown in Fig. 18.

The terminal T1 is connected to one end of a conductive pattern 242 implemented by one conductor wire. The other end of the conductive pattern 242 is connected to one end of the conductive pattern Ph implemented by one conductor wire. The other end of the conductive pattern Ph is connected to one end of a conductive pattern 241 implemented by one conductor wire. The other end of the conductive pattern 241 is connected to the terminal T5.

One end of a conductive pattern 243 implemented by one conductor wire is connected to the terminal T2. The other end of the conductive pattern 243 is connected to the terminal T11. One end of a conductive pattern 245 implemented by one conductor wire is connected to the terminal T4. The other end of the conductive pattern 245 is connected to the terminal T14. One end of a conductive pattern 244 implemented by one conductor wire is connected to the terminal T3. The terminal T12 and the terminal T13 are connected in parallel to the other end of the conductive pattern 244. The conductive patterns in the heater FPC 24 are insulated from each other. In Fig. 18, the terminal names of the heater connector 20B to which the terminal T11 to the terminal T14 are connected are written in parentheses.

In the heater FPC 24, the first thermistor th1 and the second thermistor th2 share the conductive pattern 244 for ground connection. Accordingly, compared with a case of providing a conductive pattern for the ground connection to each of the first thermistor th1 and the second thermistor th2, wires of the heater FPC 24 can be simplified, and the manufacturing cost of the power supply unit 100 can be reduced. Widths of the conductive pattern 241 and the conductive pattern 242 connected to the conductive pattern Ph can be made as large as possible in the limited heater FPC 24. Accordingly, parasitic resistances of the conductive pattern 241 and the conductive pattern 242 can be reduced, so that power can be supplied to the seat heater HTR with high efficiency.

In the heater FPC 24, the conductive pattern 244 for connecting the first thermistor th1 and the second thermistor th2 to the ground and the conductive pattern 241 for connecting the conductive pattern Ph to the ground are separately provided. Accordingly, it is possible to prevent a potential fluctuation of the conductive pattern 241 connected to the conductive pattern Ph from affecting the first thermistor th1 and the second thermistor th2. Therefore, accuracy of control using the first thermistor th1 and the second thermistor th2 can be improved, and the safety of the power supply unit 100 can be improved. A conductive pattern for connecting the first thermistor th1 to the ground and a conductive pattern for connecting the second thermistor th2 to the ground are separately provided in the heater FPC 24, and any one of the two conductive patterns may be connected to the terminal T5. In this configuration, accuracy of control using any one of the first thermistor th1 and the second thermistor th2 can also be improved.

### (Configuration and Operation of Restart Circuit RBT)

Fig. 19 is a circuit diagram in which electronic components related to the restarting of the MCU 6 are extracted from the circuit shown in Fig. 12. Fig. 19 shows the restart circuit RBT. The restart circuit RBT includes the voltage divider circuit including the resistor R3 and the resistor R4, the switch BT, the terminal KEY and the terminal GND of the main connector 20A, the switch Q7, the switch Q9, the charging IC 3, the LDO 4, and the terminal NRST of the debugging connector 20E. In the present embodiment, the restart circuit RBT enables the MCU 6 to be restarted according to an operation (for example, the long press operation) on the switch BT and a command from an external device connected to the debugging connector 20E. The MCU 6 is configured to be restarted when a signal input to the terminal P27 continues to be at a low level for a predetermined time. The charging IC 3 is configured to be restarted when a signal input to the terminal QON (⁻) continues to be at a low level for a predetermined time.

### (Resetting of MCU 6 Using Switch BT)

First, an operation when restarting the MCU 6 without using the debugging connector 20E will be described.

The resistor R3 and the resistor R4 have resistance values such that an output of the voltage divider circuit of the resistor R3 and the resistor R4 is at a high level when the switch BT is not pressed. Since this high-level signal is input to the terminal QON (⁻) of the charging IC 3, the charging IC 3 is not reset in this state and continues to output the system power supply voltage V_{SYS} from the output terminal SYS. By continuing to output the system power supply voltage V_{SYS}, the output of the system power supply voltage V_{MCU} from the output terminal OUT of the LDO 4 is also continued. Therefore, the MCU 6 continues to operate without stopping. The high-level signal is input to the gate terminal of switch Q7. Therefore, when the USB connection is established (when the bus voltage V_{BUS} is output from the charging IC 3), the switch Q7 is in the ON state, and as a result, potential of the gate terminal of the switch Q9 is at a low level (the ground level) and the switch Q9 is in the OFF state. When the switch Q9 is in the OFF state, potential of the terminal P27 of the MCU 6 is indefinite, and thus, the MCU 6 does not restart.

The resistor R3 and the resistor R4 have resistance values such that an output of the voltage divider circuit of the resistor R3 and the resistor R4 is at a low level when the switch BT is pressed. In other words, the resistor R3 and the resistor R4 have resistance values such that a value obtained by dividing the system power supply voltage V_{MCU} is at a low level. Since this low-level signal is input to the terminal QON (⁻) of the charging IC 3, if this state continues for a predetermined time, the charging IC 3 stops outputting the system power supply voltage V_{SYS} from the output terminal SYS. When the output of the system power supply voltage V_{SYS} is stopped, the voltage output from the LDO 4 is stopped, the system power supply voltage V_{MCU} is no longer input to the terminal VDD of the MCU 6, and the MCU 6 is stopped.

This low-level signal is input to the gate terminal of the switch Q7. Therefore, when the USB connection is established (when the bus voltage V_{BUS} is output from the charging IC 3), the switch Q7 is in the OFF state, and as a result, the potential of the gate terminal of the switch Q9 is at a high level (the bus voltage V_{BUS}) and the switch Q9 is in the ON state. If the switch Q9 is in the ON state, the potential of the terminal P27 of the MCU 6 is at a low level (the ground level). When the switch BT is continuously pressed for a predetermined time, a low-level signal is input to the terminal P27 of the MCU 6 for the predetermined time, and thus, the MCU 6 executes restart processing. When the pressing on the switch BT ends, the charging IC 3 restarts outputting the system power supply voltage V_{SYS}, and thus, the system power supply voltage V_{MCU} is input to the terminal VDD of the MCU 6 that is stopped, and the MCU 6 is started.

### (Resetting of MCU 6 Using Debugging Connector 20E)

When the debugging connector 20E is used to restart the MCU 6, the USB connection is established, and an external device is connected to the debugging connector 20E. If the switch BT is not pressed in this state, the switch Q9 is in the OFF state, and thus, the potential of the terminal P27 of the MCU 6 depends on the input from the external device. Therefore, when an operator operates the external device to input a low-level restart signal to the terminal NRST, the restart signal is continuously input to the terminal P27 for a predetermined time. By receiving the input of this restart signal, the MCU 6 executes the restart processing.

According to the restart circuit RBT shown in Fig. 19, the low-level signal generated by pressing the switch BT is input to the terminal P27 of the MCU 6 as well as the terminal QON (⁻) of the charging IC 3. Therefore, even if the MCU 6 is frozen, the MCU 6 can be restarted by stopping the output from the charging IC 3. Even if the charging IC 3 is not reset for some reason, if the MCU 6 is not frozen, the MCU 6 can be restarted by inputting a low-level signal to the terminal P27. In this way, the two systems can be restarted, so that the MCU 6 can be reliably restarted by a simple operation of pressing the switch BT.

According to the restart circuit RBT shown in Fig. 19, the MCU 6 can also be restarted from the external device by using the debugging connector 20E. Even when a low-level signal is input from the external device to the terminal P27 of the MCU 6, the presence of the switch Q9 prevents this signal from being transmitted to the terminal QON (⁻) of the charging IC. In this way, the signal input to the debugging connector 20E and the signal generated by the operation of the switch BT can be separated, and thus, the operation of the restart circuit RBT can be stabilized. In Fig. 19, a configuration in which the terminal NRST and the terminal QON (⁻) of the charging IC 3 are connected is also assumed, but such a configuration is not adopted in Fig. 19. Accordingly, the restart circuit RBT can be simplified compared with a case where the debugging connector 20E is connected to the terminal QON (⁻), and thus, the manufacturing cost of the power supply unit 100 can be reduced.

In the restart circuit RBT shown in Fig. 19, the MCU 6 can be restarted using the switch BT only when the USB connection is established. In this way, the MCU 6 can be restarted only when the power supply ba can be charged, so that even if the remaining amount of the power supply ba decreases when the MCU 6 is restarted, the MCU 6 can be reliably restarted by the external power supply.

### (Modification of Restart Circuit RBT)

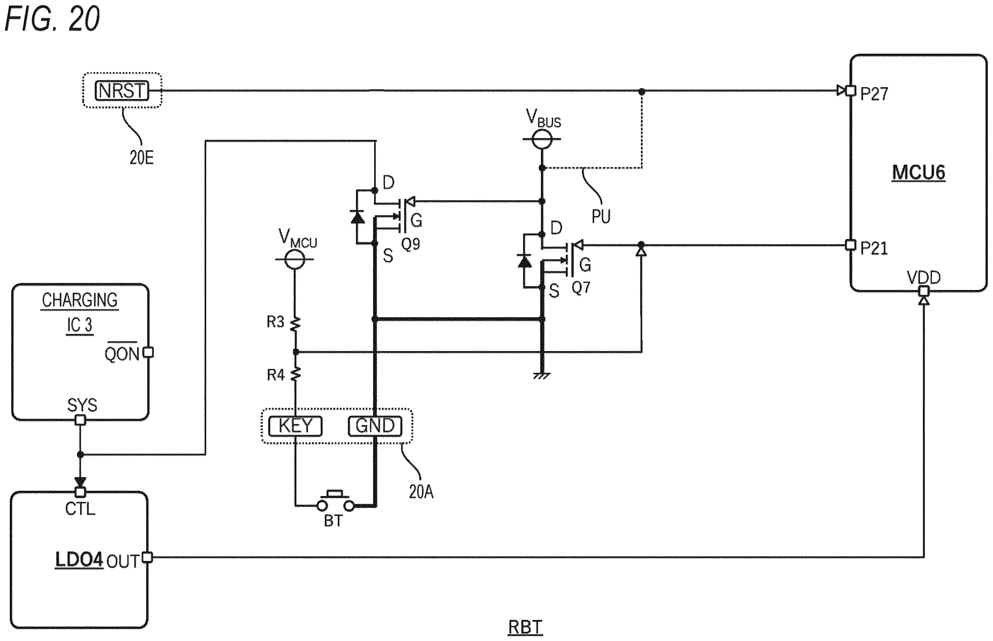

Fig. 20 shows a modification of the restart circuit RBT shown in Fig. 19. The restart circuit RBT shown in Fig. 20 has the same configuration as that shown in Fig. 19 except that the connection destination of the drain terminal of the switch Q9 is changed from the terminal P27 to the control terminal CTL of the LDO 4, and the connection between the voltage divider circuit of the resistor R3 and the resistor R4 and the terminal QON (⁻) of the charging IC 3 is deleted. In the restart circuit RBT shown in Fig. 20, when restarting the MCU 6 without using the debugging connector 20E, it is necessary to establish the USB connection.

In the restart circuit RBT shown in Fig. 20, when the USB connection is established and the switch BT is not pressed, the output of the voltage divider circuit of the resistor R3 and the resistor R4 is at a high level. The high-level signal is input to the gate terminal of switch Q7. Therefore, the switch Q7 is in the ON state, and as a result, the potential of the gate terminal of the switch Q9 is at a low level (the ground level) and the switch Q9 is in the OFF state. When the switch Q9 is in the OFF state, no low-level signal is input to the control terminal CTL of the LDO 4. Therefore, the MCU 6 continues to operate.

In the restart circuit RBT shown in Fig. 20, when the USB connection is established and the switch BT is not pressed, the output of the voltage divider circuit of the resistor R3 and the resistor R4 is at a low level. This low-level signal is input to the gate terminal of the switch Q7. Therefore, the switch Q7 is in the OFF state, and as a result, the potential of the gate terminal of the switch Q9 is at a high level (the bus voltage V_{BUS}) and the switch Q9 is in the ON state. When the switch Q9 is in the ON state, the control terminal CTL of the LDO 4 is connected to the ground, and thus, the signal input to the control terminal CTL is at a low level. The LDO 4 stops outputting the voltage from the output terminal OUT when the low-level signal is continuously input to the control terminal CTL for a predetermined time. Therefore, when the switch BT is continuously pressed for a predetermined time, the supply of the system power supply voltage V_{MCU} to the MCU 6 is stopped, and the MCU 6 is stopped. When the pressing on the switch BT ends, the switch Q9 is in the OFF state, and thus, the signal input to the control terminal CTL returns to a high level (system power supply voltage V_{SYS}). Accordingly, the LDO 4 restarts the output of the system power supply voltage V_{MCU}, so that the system power supply voltage V_{MCU} is input to the terminal VDD of the MCU 6 that is stopped, and the MCU 6 is started.

In the restart circuit RBT shown in Fig. 20, when the debugging connector 20E is used to restart the MCU 6, an external device is connected to the debugging connector 20E. In this state, when the operator operates the external device to input a low-level restart signal to the terminal NRST, the restart signal is continuously input to the terminal P27 for a predetermined time. By receiving the input of this restart signal, the MCU 6 executes the restart processing.

In the restart circuit RBT shown in Fig. 20, even if the switch BT is pressed long, a low-level signal is not input to the terminal P27 of the MCU 6. Therefore, the circuit can be made simpler than the restart circuit RBT shown in Fig. 19, and the manufacturing cost of the power supply unit 100 can be reduced.

In the restart circuit RBT shown in Fig. 20, a wire PU indicated by a dashed line in the drawing may be added. The wire PU is provided to pull up the potential of the terminal P27 of the MCU 6 to a high level by the bus voltage V_{BUS}. By adding this wire PU, the potential of the terminal P27 does not become unstable even when a low-level signal is not input to the terminal P27, and thus, the operation of the power supply unit 100 can be stabilized.

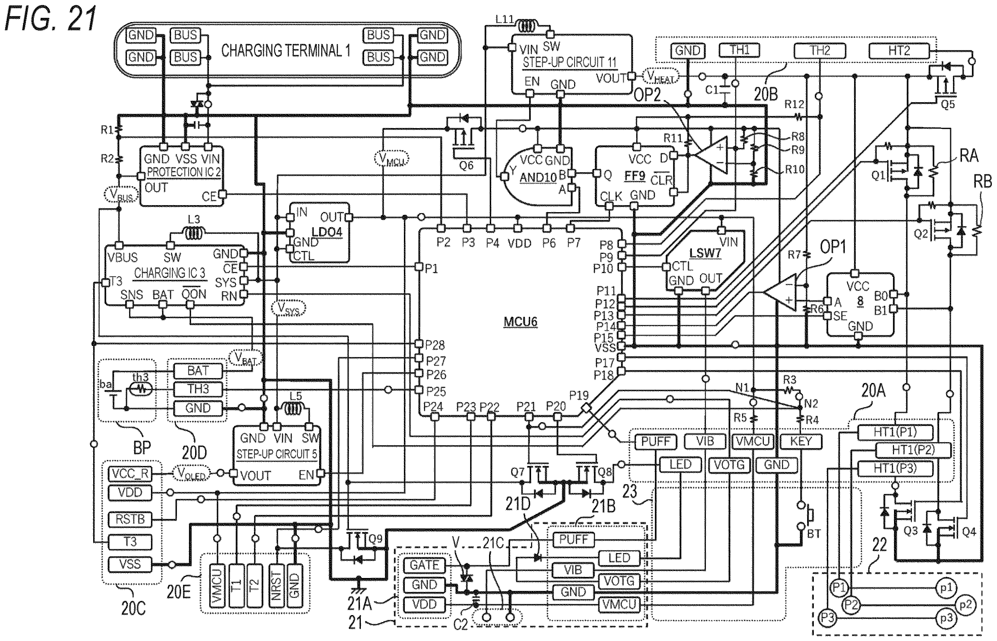

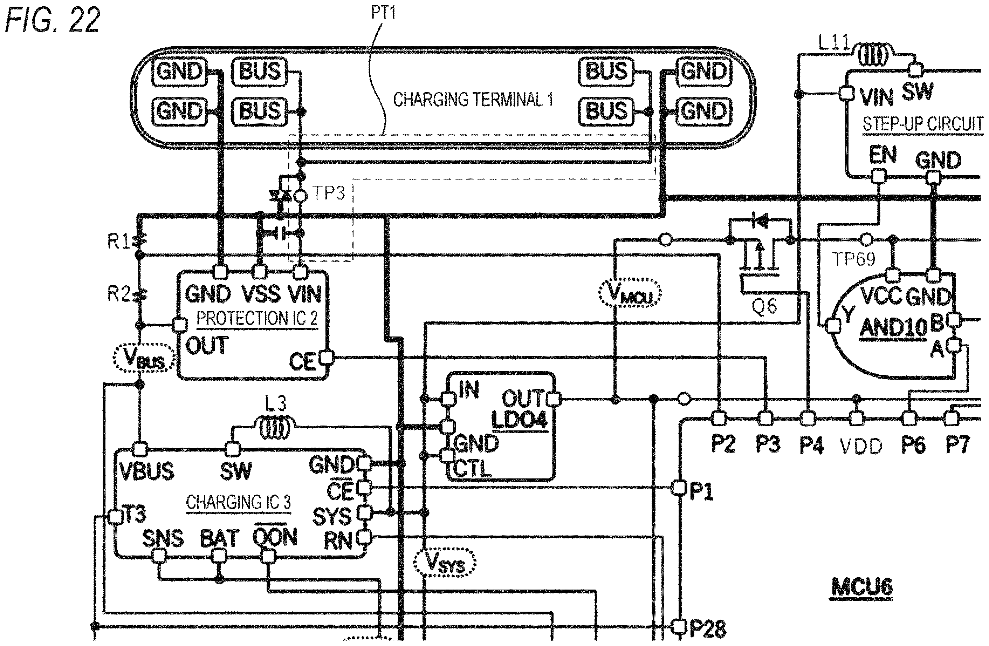

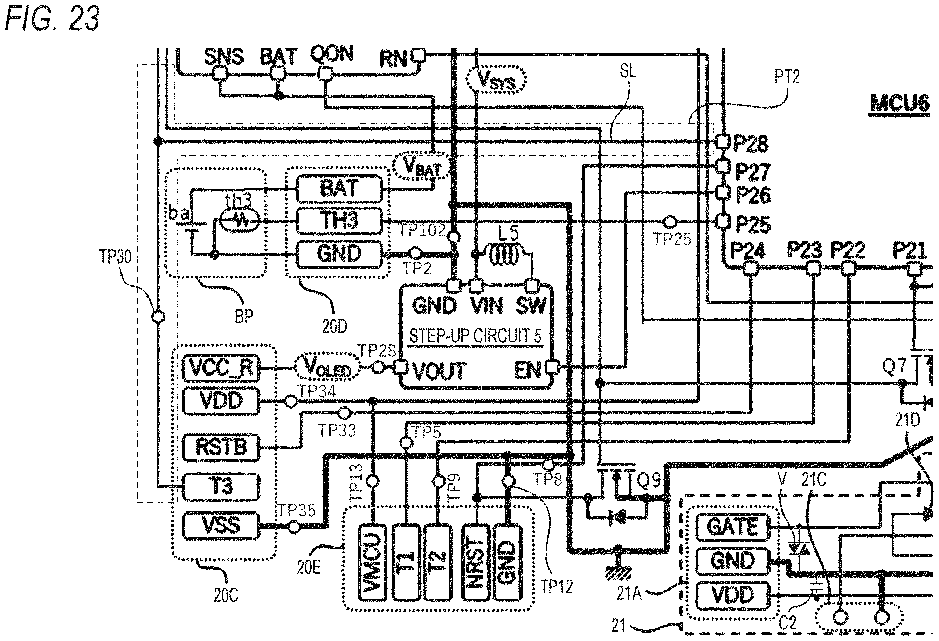

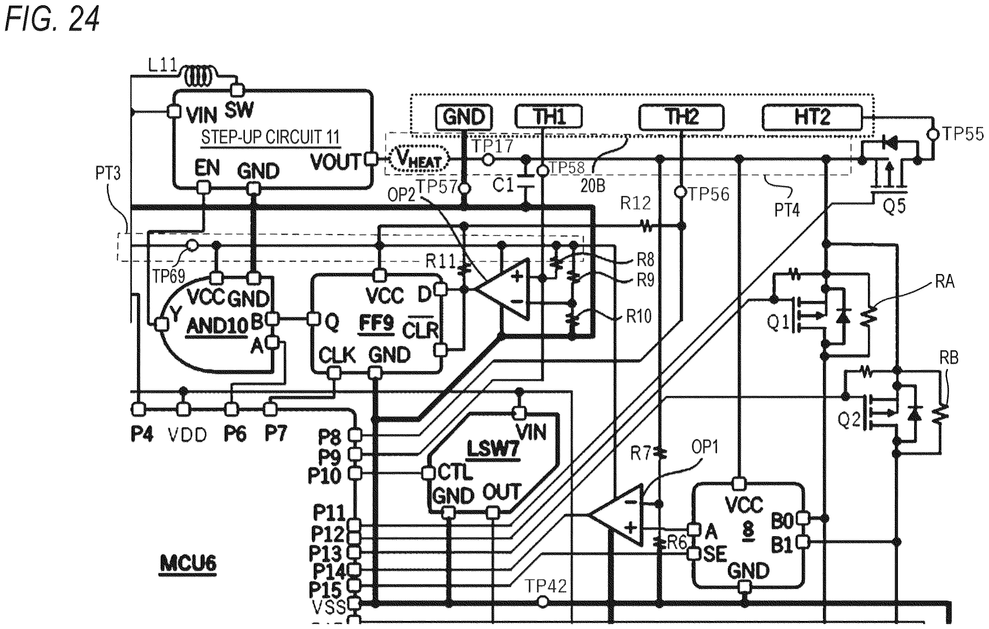

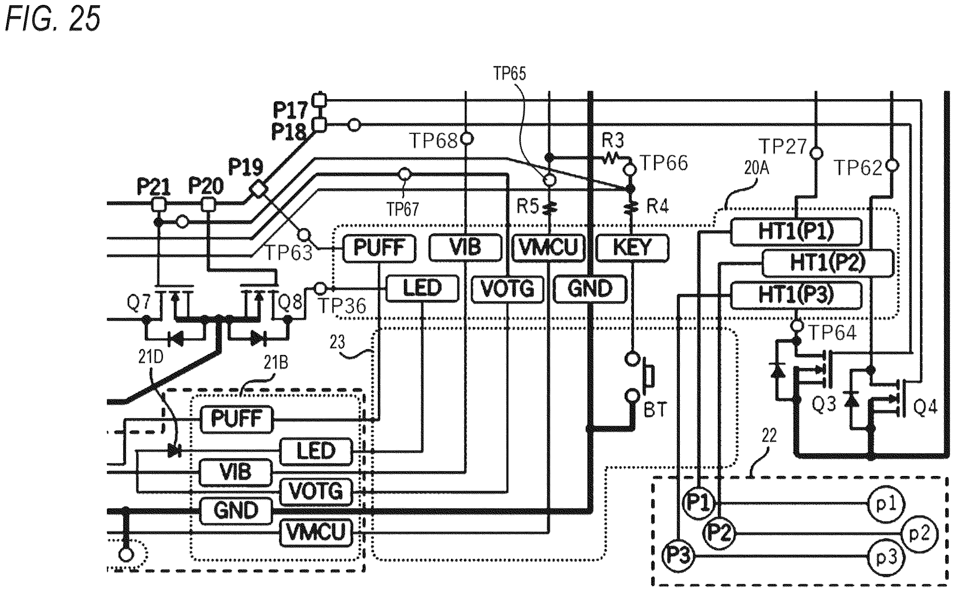

The circuit shown in Fig. 12 formed on the main board 20 is provided with test points which are conductive patterns for performing various tests. Fig. 21 is a circuit diagram in which the test points (white circles in the drawing) are added to Fig. 12. Fig. 22 is a partially enlarged view of Fig. 21, and is an enlarged view of an upper left area when Fig. 21 is divided vertically and horizontally into four. Fig. 23 is a partially enlarged view of Fig. 21, and is an enlarged view of a lower left area when Fig. 21 is divided vertically and horizontally into four. Fig. 24 is a partially enlarged view of Fig. 21, and is an enlarged view of an upper right area when Fig. 21 is divided vertically and horizontally into four. Fig. 25 is a partially enlarged view of Fig. 21, and is an enlarged view of a lower right area when Fig. 21 is divided vertically and horizontally into four.

As shown in Fig. 22, the main board 20 has a first conductive pattern PT1 which is a conductive pattern (a wire) for passing power supplied from an external power supply. A part of the first conductive pattern PT1 is provided with a test point TP3 including a conductor. The test point TP3 is provided on the front surface 201 of the main board 20.

As shown in Fig. 23, the main board 20 has a second conductive pattern PT2 (in other words, the signal line SL) which is a conductive pattern used by the MCU 6 for serial communication or parallel communication with the charging IC 3 and the control IC of the OLED panel 17. Apart of this signal line SL is provided with a test point TP30 including a conductor. The test point TP30 is provided on the front surface 201 of the main board 20.

As shown in Fig. 24, the main board 20 has a third conductive pattern PT3 which is a conductive pattern constituting a power supply line of the protection circuit. A part of the third conductive pattern PT3 is provided with a test point TP69 including a conductor. The test point TP69 is provided on the front surface 201 of the main board 20. The main board 20 has a fourth conductive pattern PT4 which is a conductive pattern that supplies heating power V_{HEAT}. A part of the fourth conductive pattern PT4 is provided with a test point TP17 including a conductor. The test point TP17 is provided on the front surface 201 of the main board 20.

As shown in Fig.23, the main board 20 is provided with test points TP28 and TP33 to TP35 including conductors in a part of the wires connected to the terminals of the OLED connector 20C except the terminal T3. The main board 20 is provided with test points TP5, TP8, TP9, TP12, and TP13 including conductors in a part of the wires connected to the terminals of the debugging connector 20E. The main board 20 is provided with test points TP25 and TP2 including conductors in a part of the wires connected to the terminal TH3 and the terminal GND of the battery connector 20D.

As shown in Fig.24, the main board 20 is provided with test points TP55 to TP58 including conductors in a part of the wires connected to the terminals of the heater connector 20B. As shown in Fig.25, the main board 20 is provided with test points TP27, TP36, and TP62 to TP68 including conductors in a part of the wires connected to the terminals of the main connector 20A.

The test points TP2 and TP25 of the wires connected to the battery connector 20D, the test points TP28 and TP33 to TP35 of the wires connected to the OLED connector 20C, the test points TP5, TP8, TP9, TP12, and TP13 of the wires connected to the debugging connector 20E, the test points TP55 to TP58 of the wires connected to the heater connector 20B, and the test points TP27, TP36, and TP62 to TP68 of the wire connected to the main connector 20A are all provided on the front surface 201 of the main board 20.

In this way, the test points of the important conductive patterns are provided on the front surface 201 facing the case 3a with the main board 20 fixed to the chassis 50. Since the connectors to which flexible wires are connected are concentrated on the front surface 201, a probe for inspection can be brought into contact with the test points while avoiding the wires easily. Such test points of the important conductive patterns are easily accessible from the outside, so that the conductive patterns can be easily verified. As a result, it is possible to improve accuracy of verification at the time of manufacturing the power supply unit 100.

On the other hand, the back surface 202 of the main board 20 is also provided with test points, although the number is smaller than that on the front surface 201 and the number is small. For example, a test point TP102 shown in Fig. 23 and a test point TP42 shown in Fig. 24 are provided on the back surface 202. Each of the test point TP42 and the test point TP102 are provided on a conductive pattern connected to the ground. In this way, test points on the ground conductive pattern, which are less important than other conductive patterns described above, are provided on the back surface 202, so that more important test points can be provided on the front surface 201. Accordingly, it is possible to improve the accuracy of verification at the time of manufacturing the power supply unit 100.

In the circuit shown in Fig. 12, the switch Q5 may be connected between the terminal GND of the heater connector 20B connected to the negative side terminal of the seat heater HTR and the ground provided on the main board 20. In this configuration, the switch Q5 is preferably of the N-channel.

In the present specification, at least the following matters are described. In parentheses, corresponding constituent components and the like in the above-mentioned embodiment are indicated, but the present invention is not limited thereto.

(1) A power supply unit (the power supply unit 100) for an aerosol generating device (the aerosol generating device 200), including:
   a power supply (the power supply ba) configured to supply power to an atomizer (the liquid heater) configured to atomize an aerosol source;
   a circuit board (main board 20) including a first main surface (the front surface 201) and a second main surface (the back surface 202) located back of the first main surface;
   a housing (the case 3a) accommodating the power supply and the circuit board;
   a plurality of electronic components accommodated in the above housing; and
   a plurality of first connectors (the main connector 20A, the heater connector 20B, the OLED connector 20C, and the battery connector 20D) respectively connected to the plurality of electronic components via a plurality of first wires (the main FPC 23, the heater FPC 24, the OLED FPC 25, and the lead wire 16) provided outside the circuit board, in which
   the plurality of first connectors are mounted only on the first main surface of the first main surface and the second main surface.

According to (1), routing of the first wires can be facilitated compared with a configuration in which the first connectors are mounted dispersedly on the first main surface and the second main surface. A total thickness of the first connectors and the circuit board can be reduced. The wires are routed easily and the total thickness of the first connectors and the circuit board is reduced, so that a design such as reduction of a surplus space is facilitated, and thus, the power supply unit is miniaturized, and usability for a user is improved.

(2) The power supply unit for an aerosol generating device according to (1), in which
a distance between an inner wall of the housing facing the first main surface and the first main surface is shorter than a distance between another inner wall of the housing facing the second main surface and the second main surface.

According to (2), since not many components are disposed near the first main surface, the first wires can be easily connected to the first connectors when manufacturing the power supply unit.

(3) The power supply unit for an aerosol generating device according to (2), in which
no other components constituting the power supply unit are present between the inner wall of the housing facing the first main surface and the first main surface.

According to (3), since no component is disposed near the first main surface, the first wires can be easily connected to the first connectors when manufacturing the power supply unit.

(4) The power supply unit for an aerosol generating device according to any one of (1) to (3), in which
the power supply is disposed by a surface different from the first main surface among a plurality of surfaces of the circuit board.

According to (4), since the power supply, which can be made large, is not disposed near the first main surface, the first wires can be easily connected to the first connectors when manufacturing the power supply unit.

(5) The power supply unit for an aerosol generating device according to any one of (1) to (4), in which
the plurality of first wires pass by one side surface (the left side surface 20SL) among a plurality of side surfaces of the circuit board.

According to (5), the first wires can be easily connected to the first connectors as compared with a case where the plurality of first wires pass by the plurality of side surfaces of the circuit board, and thus, not only can the power supply unit be manufactured easily, but also the routing of the first wires in the housing can be simplified. A total thickness of the circuit board and the first wires is reduced, so that a design such as the reduction of the surplus space can be facilitated, and thus, the power supply unit is miniaturized, and the usability for the user is improved.

(6) The power supply unit for an aerosol generating device according to (5), in which
insertion directions of the first wires in the plurality of first connectors are the same.

According to (6), the first wires can be prevented from being unnecessarily long, and thus, the power supply unit can be miniaturized and cost thereof can be reduced.

(7) The power supply unit for an aerosol generating device according to (5) or (6), in which
the plurality of first wires pass by the one side surface (the left side surface 20SL) orthogonal to a short transverse direction among the plurality of side surfaces (the left side surface 20SL, the right side surface 20SR, the upper side surface 20SU, and the lower side surface 20SD) of the circuit board.

According to (7), compared with a case where the first wires pass by a side surface perpendicular to a longitudinal direction of the circuit board, overlapping between the wires can be reduced and more wires can be connected to the circuit board, and thus, high functionality can be achieved without increasing the size of the power supply unit.

(8) The power supply unit for an aerosol generating device according to any one of (1) to (7), further including:
a second connector (the debugging connector 20E) configured to be connected to a device (a personal computer) other than the power supply unit via a second wire (the connection cable (not shown)), in which
the second connector is mounted on the second main surface.

According to (8), the second wire is not normally connected to the second connector connected to an external device of the power supply unit. By mounting such a second connector on the second main surface, more first connectors can be mounted on the first main surface, and thus, the power supply unit can be miniaturized.

(9) The power supply unit for an aerosol generating device according to (8), in which
insertion directions of the first wires with respect to the first connectors are different from an insertion direction of the second wire with respect to the second connector.

According to (9), interference with the first wires is prevented when the second wire is inserted into the second connector, and thus,the second wire can be easily inserted into the second connector. The first connector and the first wires are less likely to be damaged when the second wire is inserted.

(10) The power supply unit for an aerosol generating device according to (9), in which
the insertion directions of the first wires with respect to the first connectors are opposite to the insertion direction of the second wire with respect to the second connector.

According to (10), the interference with the first wires is further prevented when the second wire is inserted into the second connector, and thus, the second wire can be further easily inserted into the second connector. The first connector and the first wires are less likely to be damaged when the second wire is inserted.

(11) The power supply unit for an aerosol generating device according to (10), further including:
a chassis (the chassis 50)supporting the housing and the circuit board, in which
the housing includes a first portion (the first case 3A) and a second portion (the second case 3B) that are independently removable from the chassis,
the second portion is configured to allow the second wire to be inserted into the second connector when only the second portion of the first portion and the second portion is removed from the chassis, and
the first wires are not exposed in a state where only the second portion of the first portion and the second portion is removed from the chassis.

According to (11), if the second wire is inserted and removed in a state where only the second portion is removed from the chassis, there is no risk of direct contact with the first connectors or the first wires, and thus, the first connectors and the first wires are less likely to be damaged when the second wire is inserted.

(12) The power supply unit for an aerosol generating device according to any one of (8) to (11), further including:
a third connector (the charging terminal 1) configured to be connected to the device (the external power supply) other than the power supply unit via a third wire (the USB cable (not shown)), in which
the third connector is mounted on the second main surface, and
an insertion direction of the second wire with respect to the second connector is different from an insertion direction of the third wire with respect to the third connector.

According to (12), even when the second wire and the third wire are connected to respective connectors thereof at the same time, the second wire and the third wire do not interfere with each other, and thus, even when it is necessary to connect the second wire and the third wire at the same time, such a connection state can be easily achieved.

(13) The power supply unit for an aerosol generating device according to any one of (1) to (12), in which
a number of test points provided on the first main surface is greater than a number of test points provided on the second main surface.

When manufacturing the power supply unit, electrical connection between the electronic components and the circuit board is established by connecting the first wires to the plurality of first connectors of the circuit board whose position is fixed in the power supply unit. The wires are usually flexible. According to (13), many test points are disposed on the first main surface provided with the first connectors to which such flexible wires are connected, so that many test points can be easily probed. Therefore, by improving accuracy of verification at the time of manufacturing, a marketability can be improved, and at the same time, a time required for verification can be shortened.

(14) The power supply unit for an aerosol generating device according to any one of (1) to (13), in which
the circuit board includes a first conductive pattern (the first conductive pattern PT1) which is a conductive pattern for passing power supplied from an external power supply, and a first test point (the test point TP3) which is a test point of the first conductive pattern, and
the first test point is provided on the first main surface.

According to (14), since the conductive pattern which is an important pattern and is for passing power supplied from the external power supply can be easily verified, the accuracy of the verification at the time of manufacturing is improved, and the marketability is improved.

(15) The power supply unit for an aerosol generating device according to any one of (1) to (14), further including:
a controller (the MCU 6), in which
the circuit board includes a second conductive pattern (the second conductive pattern PT2) which is a conductive pattern used by the controller for serial communication or parallel communication, and a second test point (the test point TP30) which is a test point of the second conductive pattern, and
the second test point is provided on the first main surface.

According to (15), since the conductive pattern which is an important pattern and is for serial communication or parallel communication can be easily verified, the accuracy of the verification at the time of manufacturing is improved, and the marketability is improved.

(16)The power supply unit for an aerosol generating device according to any one of (1) to (15), further including:
a protection circuit (the AND gate 10, the FF 9, and the operational amplifier OP2) configured to cut off power supplied to the atomizer, in which
the circuit board includes a third conductive pattern (the third conductive pattern PT3) which is a conductive pattern constituting the protection circuit, and a third test point (the test point TP69) which is a test point of the third conductive pattern, and
the third test point is provided on the first main surface.

According to (16), since the conductive pattern which is an important pattern and constitutes the protection circuit can be easily verified, the accuracy of the verification at the time of manufacturing is improved, and the marketability is improved.

(17) The power supply unit for an aerosol generating device according to any one of (1) to (16), in which
the circuit board includes a fourth conductive pattern (the fourth conductive pattern PT4) which is a conductive pattern for supplying atomization power (the heating power VHEAT) to the atomizer, and a fourth test point (the test point TP17) which is a test point of the fourth conductive pattern, and
the fourth test point is provided on the first main surface.

According to (17), since the conductive pattern which is an important pattern and through which the heating power flows can be easily verified, the accuracy of the verification at the time of manufacturing is improved, and the marketability is improved.

(18) The power supply unit for an aerosol generating device according to any one of (1) to (17), wherein
the circuit board includes a fifth conductive pattern which is a conductive pattern connected to the first connectors, and a fifth test point (the test points TP2 and TP25 of the wires connected to the battery connector 20D, the test points TP28 and TP33 to TP35 of the wires connected to the OLED connector 20C, the test points TP5, TP8, TP9, TP12, and TP13 of the wires connected to the debugging connector 20E, the test points TP55 to TP58 of the wires connected to the heater connector 20B, and the test points TP27, TP36, and TP62 to TP68 of the wires connected to the main connector 20A) which is a test point of the fifth conductive pattern, in which
the fifth test point is provided on the first main surface.

According to (18), since the conductive pattern which is an important pattern and is connected to the connector can be easily verified, the accuracy of the verification at the time of manufacturing is improved, and the marketability is improved.

(19)The power supply unit for an aerosol generating device according to any one of (1) to (18), in which
the circuit board includes a sixth conductive pattern which is a conductive pattern connected to ground, and a sixth test point (the test points TP42 and TP102) which is a test point of the sixth conductive pattern, and
the sixth test point is provided on the second main surface.

According to (19), the test point of the conductive pattern for grounding, which is less important than other conductive patterns, is provided on the second main surface, so that more important test points can be provided on the first main surface, and thus, the marketability is improved by improving the accuracy of the verification at the time of manufacturing.

(20) The power supply unit for an aerosol generating device according to any one of (1) to (19), in which
the plurality of first wires include a folded wire (the main FPC 23) which is a wire obtained by folding and a remaining first wires among the plurality of first wires, the remaining first wires being disposed so as to cover the folded wire when viewed from a housing side.

According to (20), by suppressing the wire obtained by folding with other wires, the folding of the wire is maintained. Therefore, it is possible to prevent occurrence of stress in the folded wire and other wires due to loosening of the folding. Since the wire obtained by folding can reduce a volume of a space occupied by the wires in the housing, the power supply unit is miniaturized, and the usability for the user is improved.

(21) The power supply unit for an aerosol generating device according to any one of (1) to (19), in which
the plurality of first wires include a folded wire (the main FPC 23) which is a wire obtained by folding, and
the folded wire is disposed at an innermost position among the plurality of first wires when viewed from a housing side.

According to (21), by suppressing the wire obtained by folding with other wires, the folding of the wire is maintained. Therefore, it is possible to prevent occurrence of stress in the folded wire and other wires due to loosening of the folding. Since the wire obtained by folding can reduce the volume of the space occupied by the wires in the housing, the power supply unit is miniaturized, and the usability for the user is improved.

### REFERENCE SIGNS LIST

100 power supply unit
1 charging terminal
ba power supply
20 main board
201 front surface
202 back surface
23 main FPC
24 heater FPC
25 OLED FPC
16 lead wire
20A main connector
20B heater connector
20C OLED connector
20D battery connector
20E debugging connector
3a case

## Claims

1. A power supply unit for an aerosol generating device, comprising:
a power supply configured to supply power to an atomizer that atomize an aerosol source;
a circuit board including a first main surface and a second main surface located back of the first main surface;
a housing accommodating the power supply and the circuit board;
a plurality of electronic components accommodated in the housing; and
a plurality of first connectors respectively connected to the plurality of electronic components via a plurality of first wires provided outside the circuit board, wherein
the plurality of first connectors are mounted only on the first main surface of the first main surface and the second main surface.

2. The power supply unit for an aerosol generating device according to claim 1, wherein
a distance between an inner wall of the housing facing the first main surface and the first main surface is shorter than a distance between another inner wall of the housing facing the second main surface and the second main surface.

3. The power supply unit for an aerosol generating device according to claim 2, wherein
no other components constituting the power supply unit are present between the inner wall of the housing facing the first main surface and the first main surface.

4. The power supply unit for an aerosol generating device according to any one of claims 1 to 3, wherein
the power supply is disposed by a surface different from the first main surface among a plurality of surfaces of the circuit board.

5. The power supply unit for an aerosol generating device according to any one of claims 1 to 4, wherein
the plurality of first wires pass by one side surface among a plurality of side surfaces of the circuit board.

6. The power supply unit for an aerosol generating device according to claim 5, wherein
insertion directions of the first wires in the plurality of first connectors are the same.

7. The power supply unit for an aerosol generating device according to claim 5 or 6, wherein
the plurality of first wires pass by the one side surface orthogonal to a short transverse direction among the plurality of side surfaces of the circuit board.

8. The power supply unit for an aerosol generating device according to any one of claims 1 to 7, further comprising:
a second connector configured to be connected to a device other than the power supply unit via a second wire, wherein
the second connector is mounted on the second main surface.

9. The power supply unit for an aerosol generating device according to claim 8, wherein
insertion directions of the first wires with respect to the first connectors are different from an insertion direction of the second wire with respect to the second connector.

10. The power supply unit for an aerosol generating device according to claim 9, wherein
the insertion directions of the first wires with respect to the first connectors are opposite to the insertion direction of the second wire with respect to the second connector.

11. The power supply unit for an aerosol generating device according to claim 10, further comprising:
a chassis supporting the housing and the circuit board, wherein
the housing includes a first portion and a second portion that are independently removable from the chassis,
the second portion is configured to allow the second wire to be inserted into the second connector when only the second portion of the first portion and the second portion is removed from the chassis, and
the first wires are not exposed in a state where only the second portion of the first portion and the second portion is removed from the chassis.

12. The power supply unit for an aerosol generating device according to any one of claims 8 to 11, further comprising:
a third connector configured to be connected to the device other than the power supply unit via a third wire, wherein
the third connector is mounted on the second main surface, and
an insertion direction of the second wire with respect to the second connector is different from an insertion direction of the third wire with respect to the third connector.

13. The power supply unit for an aerosol generating device according to any one of claims 1 to 12, wherein
a number of test points provided on the first main surface is greater than a number of test points provided on the second main surface.

14. The power supply unit for an aerosol generating device according to any one of claims 1 to 13, wherein
the circuit board includes a first conductive pattern and a first test point, the first conductive pattern being a conductive pattern for passing power supplied from an external power supply, and the first test point being a test point of the first conductive pattern, and
the first test point is provided on the first main surface.

15. The power supply unit for an aerosol generating device according to any one of claims 1 to 14, further comprising:
a controller, wherein
the circuit board includes a second conductive pattern and a second test point, the second conductive pattern being a conductive pattern used by the controller for serial communication or parallel communication, and the second test point being a test point of the second conductive pattern, and
the second test point is provided on the first main surface.

16. The power supply unit for an aerosol generating device according to any one of claims 1 to 15, further comprising:
a protection circuit configured to cut off power supplied to the atomizer, wherein
the circuit board includes a third conductive pattern and a third test point, the third conductive pattern being a conductive pattern constituting the protection circuit, and the third test point being a test point of the third conductive pattern, and
the third test point is provided on the first main surface.

17. The power supply unit for an aerosol generating device according to any one of claims 1 to 16, wherein
the circuit board includes a fourth conductive pattern and a fourth test point, the fourth conductive pattern being a conductive pattern for supplying atomization power to the atomizer, and the fourth test point being a test point of the fourth conductive pattern, and
the fourth test point is provided on the first main surface.

18. The power supply unit for an aerosol generating device according to any one of claims 1 to 17, wherein
the circuit board includes a fifth conductive pattern and a fifth test point, the fifth conductive pattern being a conductive pattern connected to the first connectors, and the fifth test point being a test point of the fifth conductive pattern, wherein
the fifth test point is provided on the first main surface.

19. The power supply unit for an aerosol generating device according to any one of claims 1 to 18, wherein
the circuit board includes a sixth conductive pattern and a sixth test point, the sixth conductive pattern being a conductive pattern connected to ground, and the sixth test point being a test point of the sixth conductive pattern, and
the sixth test point is provided on the second main surface.

20. The power supply unit for an aerosol generating device according to any one of claims 1 to 19, wherein
the plurality of first wires include a folded wire which is a wire obtained by folding and a remaining first wires among the plurality of first wires, the remaining first wires being disposed so as to cover the folded wire when viewed from a housing side.

21. The power supply unit for an aerosol generating device according to any one of claims 1 to 19, wherein
the plurality of first wires include a folded wire which is a wire obtained by folding, and
the folded wire is disposed at an innermost position among the plurality of first wires when viewed from a housing side.
